# EUROPEAN PATENT APPLICATION

(11) **EP 4 827 283 A1**
(43) Date of publication of application: **21.10.2026**
(21) Application number: 26166978.2
(22) Date of filing: 24.03.2026
(51) Int. Cl.: H10H 29/32, H10H 29/80, H10H 29/01, H10H 29/03, H10H 29/14

(54) **DISPLAY APPARATUS AND METHOD OF MANUFACTURING THE SAME**

(30) Priority: 16.04.2025 KR 20250049695
(71) Applicant: Samsung Electronics Co., Ltd, Suwon-si, Gyeonggi-do 16677 (KR)
(72) Inventor: SHIN, Dongchul, 16677 Suwon-si (KR); PARK, Junghun, 16677 Suwon-si (KR); OH, Youngtek, 16677 Suwon-si (KR); HAN, Joohun, 16677 Suwon-si (KR); HWANG, Kyungwook, 16677 Suwon-si (KR)
(74) Representative: Arnold & Siedsma

(57) **Abstract**

A display apparatus includes a display layer including a plurality of light-emitting devices, and a drive layer configured to drive the plurality of light-emitting devices, where at least one of the plurality of light-emitting devices includes a light-emitting structure including a first light-emitting element, a second light-emitting element, and a third light-emitting element sequentially and monolithically stacked from the drive layer in a first direction, each of the first light-emitting element, the second light-emitting element, and the third light-emitting element including a p-type semiconductor layer, an active layer, and an n-type semiconductor layer, where the n-type semiconductor layer of the first light-emitting element includes AlGaN and a doping amount of an n-type dopant in the n-type semiconductor layer of the first light-emitting element is 2E+19/cm³ or more.

## Description

### BACKGROUND

### 1. Field

The disclosure relates to a display apparatus and a method of manufacturing the same.

### 2. Description of Related Art

Light-emitting diodes (LEDs) are considered as next-generation light sources due to advantages such as long life, low power consumption, fast response speed, and environmental friendliness compared to conventional light sources. Thus, the industrial demand for LEDs is increasing due to these advantages. LEDs are generally applied to and used in various products such as lighting devices and backlights of display apparatuses. Recently, micro-scale micro-LEDs using group II-VI or group III-V compound semiconductors have been developed.

In addition, a micro-LED display apparatus in which such micro-LEDs are directly applied as light-emitting elements of display pixels has been developed. Research is underway on methods of manufacturing light-emitting elements for each sub-pixel and methods of manufacturing light-emitting elements for each pixel.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

Provided are a display apparatus and a method of manufacturing the same, the display apparatus including a monolithic light-emitting structure having an epitaxial structure in which a plurality of light-emitting elements emitting light of different wavelengths are vertically stacked.

Provided are a display apparatus including a light-emitting structure that may be capable of having improved light emission efficiency and a method of manufacturing the same.

Additional aspects will be set forth in part in the description which follows and, in part, will be apparent from the description, or may be learned by practice of the presented embodiments of the disclosure.

According to an aspect of the disclosure, a display apparatus may include a display layer including a plurality of light-emitting devices, and a drive layer configured to drive the plurality of light-emitting devices, where at least one of the plurality of light-emitting devices may include a light-emitting structure including a first light-emitting element, a second light-emitting element, and a third light-emitting element sequentially and monolithically stacked from the drive layer in a first direction, each of the first light-emitting element, the second light-emitting element, and the third light-emitting element including a p-type semiconductor layer, an active layer, and an n-type semiconductor layer, and being respectively configured to emit light of different wavelengths, a first electrode pattern connected to the n-type semiconductor layer of the first light-emitting element, the n-type semiconductor layer of the second light-emitting element, and the n-type semiconductor layer of the third light-emitting element, and a second electrode pattern electrically connected to the p-type semiconductor layer of the first light-emitting element, the p-type semiconductor layer of the second light-emitting element, and the p-type semiconductor layer of the third light-emitting element, where the n-type semiconductor layer of the first light-emitting element includes AlGaN and a doping amount of an n-type dopant in the n-type semiconductor layer of the first light-emitting element is 2E+19/cm³ or more.

An aluminum content in the n-type semiconductor layer of the first light-emitting element may be in a range of 20 at% to 40 at%.

The p-type semiconductor layer of the first light-emitting element may include GaN, and may include an aluminum content of 0 at%.

In the first direction, a thickness of the n-type semiconductor layer of the first light-emitting element may be less than a thickness of the p-type semiconductor layer of the first light-emitting element.

In the first direction, a thickness of the n-type semiconductor layer of the first light-emitting element may be less than a thickness of the n-type semiconductor layer of the third light-emitting element.

In the first direction, the n-type semiconductor layer of the first light-emitting element may have a thickness in a range of 30 nm to 300 nm.

The n-type semiconductor layer of the third light-emitting element may include GaN, and may include an aluminum content of 0 at%.

In the first direction, a distance from the active layer of the first light-emitting element to a surface of the light-emitting structure may be 1500 nm or less.

The first electrode pattern may include a first electrode that penetrates the second light-emitting element and the third light-emitting element in the first direction and contacts the n-type semiconductor layer of the first light-emitting element.

In the first direction, the first electrode may penetrate less than halfway through the n-type semiconductor layer of the first light-emitting element.

In the first direction, the first electrode may penetrate less than or equal to half of a thickness of the n-type semiconductor layer of the first light-emitting element.

The first electrode may include a first hole including an insulating material, penetrating the second light-emitting element and the third light-emitting element in the first direction, and exposing the n-type semiconductor layer of the first light-emitting element, a first n-type contact layer in the first hole and contacting the n-type semiconductor layer of the first light-emitting element, and a first conductive layer in the first hole and contacting the first n-type contact layer.

A thickness, in the first direction, of the first n-type contact layer in an edge region of the first n-type contact layer may be different from a thickness, in the first direction of the first n-type contact layer in a center region of the first n-type contact layer, and the center region and the edge region are spaced apart in a second direction perpendicular to the first direction.

A thickness, in the first direction, of the first n-type contact layer may gradually increases from an edge region of the first n-type contact layer to a center region of the first n-type contact layer, and the center region and the edge region are spaced apart in a second direction perpendicular to the first direction.

The first conductive layer may protrude toward the third light-emitting element.

The first n-type contact layer may protrude toward the third light-emitting element.

According to an aspect of the disclosure, an electronic device may include a display panel including a display layer including a plurality of light-emitting devices and a drive layer configured to drive the plurality of light-emitting devices, and a controller configured to control the display panel based on an image signal, where at least one of the plurality of light-emitting devices may include a light-emitting structure including a first light-emitting element, a second light-emitting element, and a third light-emitting element sequentially and monolithically stacked in a first direction, each of the first light-emitting element, the second light-emitting element, and the third light-emitting element including a p-type semiconductor layer, an active layer, and an n-type semiconductor layer, and being respectively configured to emit light of different wavelengths, a first electrode pattern connected to the n-type semiconductor layer of the first light-emitting element, the n-type semiconductor layer of the second light-emitting element, and the n-type semiconductor layer of the third light-emitting element, and a second electrode pattern electrically connected to the p-type semiconductor layer of the first light-emitting element, the p-type semiconductor layer of the second light-emitting element, and the p-type semiconductor layer of the third light-emitting element. For example, the display panel of the electronic device may comprise the display apparatus according to any of the above-described embodiments, or at least a part thereof, in particular the display layer and the drive layer according to any of the embodiments described above.

According to an aspect of the disclosure, a method of manufacturing a display apparatus may include forming a light-emitting structure including a first light-emitting element, a second light-emitting element, and a third light-emitting element stacked in a first direction, wherein each of the first light-emitting element, the second light-emitting element, and the third light-emitting element includes a p-type semiconductor layer, an active layer, and an n-type semiconductor layer, and are respectively configured to emit light of different wavelengths, forming a second electrode pattern connected to the p-type semiconductor layer of the first light-emitting element, the p-type semiconductor layer of the second light-emitting element, and the p-type semiconductor layer of the third light-emitting element, connecting the second electrode pattern to a drive layer that is configured to drive the light-emitting structure, removing a sacrificial layer from the light-emitting structure, and forming a first electrode pattern connected to the n-type semiconductor layer of the first light-emitting element and the n-type semiconductor layer of the second light-emitting element, where the n-type semiconductor layer of the first light-emitting element includes AlGaN and a doping amount of an n-type dopant in the n-type semiconductor layer of the first light-emitting element is 2E+19/cm³ or more.

In the first direction, a thickness of the n-type semiconductor layer of the first light-emitting element may be less than a thickness of the p-type semiconductor layer of the first light-emitting element.

In the first direction, a thickness of the n-type semiconductor layer of the first light-emitting element may be in a range of 100 nm to 300 nm.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram illustrating a portion of a display apparatus according to an embodiment;
FIG. 2 is a graph illustrating selective etching of an AlGaN layer and a GaN layer according to an embodiment;
FIG. 3 is a table showing surface characteristics according to doping concentration of each material according to an embodiment;
FIG. 4 is a graph illustrating a result of analyzing surface reflectivity according to a doping concentration according to an embodiment.
FIG. 5 is a diagram illustrating a portion of a display apparatus according to an embodiment;
FIG. 6 is a diagram illustrating a portion of a display apparatus according to an embodiment;
FIG. 7 is a diagram illustrating a portion of a display apparatus according to an embodiment;
FIG. 8 is a diagram illustrating a display apparatus including a light-emitting device in which electrode patterns are arranged on the same surface of a light-emitting structure according to an embodiment;
FIG. 9 is a diagram illustrating a display apparatus including a pixel partition according to an embodiment;
FIG. 10 is a diagram illustrating a display apparatus including an optical layer that controls an optical path according to an embodiment;
FIG. 11 is a diagram illustrating a display apparatus to which light-emitting devices are connected according to an embodiment;
FIG. 12 is a flowchart illustrating a method of manufacturing a display apparatus according to an embodiment;
FIGS. 13, 14, 15, 16, 17, 18, 19, 20, 21 and 22 are diagrams illustrating a method of manufacturing a display apparatus according to an embodiment;
FIG. 23 is a block diagram schematically illustrating an electronic device including a display apparatus according to an embodiment;
FIG. 24 illustrates an example in which a display apparatus according to an embodiment is applied to a mobile device;
FIG. 25 is a diagram illustrating an example in which a display apparatus according to an embodiment is applied to a vehicle;
FIG. 26 is a diagram illustrating an example in which a display apparatus according to an embodiment is applied to augmented reality glasses or virtual reality glasses;
FIG. 27 is a diagram illustrating an example in which a display apparatus according to an embodiment is applied to a large signage; and
FIG. 28 is a diagram illustrating an example in which a display apparatus according to an embodiment is applied to a display of a wearable device.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, embodiments will be described in detail with reference to the accompanying drawings. The embodiments described below are merely examples and various modifications are possible from these embodiments. In the following drawings, the same reference numerals refer to the same components, and the size of each component in the drawings may be exaggerated for clarity and convenience of description.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

Terms such as first and second may be used to describe various components, but are used only for the purpose of distinguishing one component from another. These terms do not limit the difference in the material or structure of the components.

Singular expressions include plural expressions unless the context clearly means otherwise. In addition, when a part "contains" a component, this means that it may contain other components, rather than excluding other components, unless otherwise stated.

Furthermore, the terms "unit", "module" or the like mean a unit that processes at least one function or operation, which may be implemented in hardware or software or implemented in a combination of hardware and software.

The specific implementations described in the present embodiments are examples and do not limit the technical scope in any way. For simplicity of the specification, descriptions of conventional electronic configurations, control systems, software, and other functional aspects of the systems may be omitted. In addition, the connection or connection members of lines between the components shown in the drawings illustratively represent functional connection and/or physical or circuit connections, and may be replaceable or represented as various additional functional connections, physical connections, or circuit connections in an actual device.

The use of the term "the" and similar indicative terms may correspond to both singular and plural.

Operations constituting the method may be performed in an appropriate order unless there is a clear statement that the operations should be performed in the order described. In addition, the use of all illustrative terms (e.g., etc.) is simply intended to detail technical ideas and, unless limited by the claims, the scope of rights is not limited due to the terms.

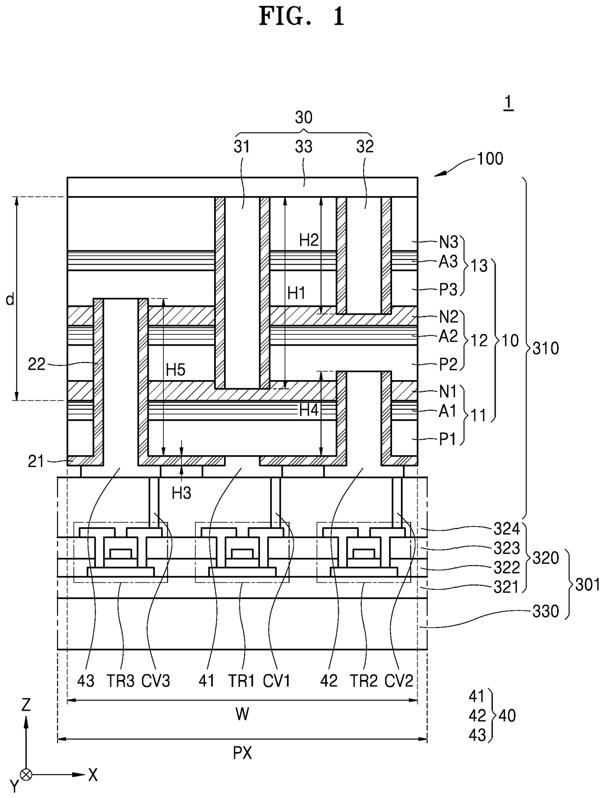

FIG. 1 is a diagram illustrating a portion of a display apparatus 1 according to an embodiment. Referring to FIG. 1, the display apparatus 1 may include a display layer 310 including a plurality of light-emitting devices 100, a drive layer 320 driving the plurality of light-emitting devices 100, and a substrate 330 supporting the drive layer 320. The drive layer 320 and the substrate 330 are collectively referred to as a backplane 301.

The display layer 310 may include the plurality of light-emitting devices 100. Although FIG. 1 illustrates one light-emitting device 100 for convenience of explanation, the plurality of light-emitting devices 100 may be also arranged on the display layer 310. At least some of the plurality of light-emitting devices 100 may include inorganic light-emitting diodes, and may emit light having specific wavelengths according to materials included in the light-emitting devices 100. A light-emitting device 100 according to an embodiment may have a micro size. For example, a width W of the light-emitting device 100 may be about 10 µm or less, about 5 µm or less, or about 3 µm or less.

The light-emitting device 100 according to an embodiment may include a light-emitting structure 10 in which a plurality of light-emitting elements 11, 12, and 13 emitting light of different wavelengths are monolithically stacked. A cross section parallel to the width direction of the light-emitting structure 10, that is, a transverse cross section, may be circular, elliptical, and/or polygonal. For example, the transverse cross-section of the light-emitting structure 10 may have a rectangular shape. A cross section parallel to the light-emitting structure 10 in a thickness direction (e.g., a Z-axis direction) may have a rectangular shape. For example, the side cross-section of the light-emitting structure 10 may have a rectangular or trapezoidal shape.

The light-emitting structure 10 may be a structure in which a first light-emitting element 11 emitting light of a first wavelength, a second light-emitting element 12 emitting light of a second wavelength that is different from the first wavelength, and a third light-emitting element 13 emitting light of a third wavelength that is different from the first wavelength and the second wavelength are stacked in the thickness direction (e.g., a Z-axis direction) of the light-emitting structure 10. For example, the first light-emitting element 11 may emit red light, the second light-emitting element 12 may emit green light, and the third light-emitting element 13 may emit blue light. As will be described later, the light-emitting structure 10 may be formed by sequentially monolithically growing the third light-emitting element 13, the second light-emitting element 12, and the first light-emitting element 11 on one sacrificial layer. Thus, the light-emitting structure 10 may not include a bonding material for coupling the light-emitting elements 11, 12, and 13 with each other.

From the perspective of the display apparatus 1, the first light-emitting element 11 may be a component of a first sub-pixel, the second light-emitting element 12 may be a component of a second sub-pixel, and the third light-emitting element 13 may be a component of a third sub-pixel. The light-emitting structure 10 including the first light-emitting element 11, the second light-emitting element 12, and the third light-emitting element 13 may be a pixel.

The first light-emitting element 11 may include a p-type semiconductor layer P1, an active layer A1 arranged on the p-type semiconductor layer P1, and an n-type semiconductor layer N1 arranged on the active layer A1. The second light-emitting element 12 may include a p-type semiconductor layer P2 arranged on the n-type semiconductor layer N1 of the first light-emitting element 11, an active layer A2 arranged on the p-type semiconductor layer P2, and an n-type semiconductor layer N2 arranged on the active layer A2. The third light-emitting element 13 may include a p-type semiconductor layer P3 arranged on the n-type semiconductor layer N2 of the second light-emitting element 12, an active layer A3 arranged on the p-type semiconductor layer P3, and an n-type semiconductor layer N3 arranged on the active layer A3.

Each of the p-type semiconductor layers P1, P2, and P3 and the n-type semiconductor layers N1, N2, and N3 may include a group II-IV or III-V compound semiconductor material, in particular a nitride semiconductor material. For example, each of the p-type semiconductor layers P1, P2, and P3 and the n-type semiconductor layers N1, N2, and N3 may include at least one nitride semiconductor material among InAlGaN, GaN, AlGaN, InGaN, AlN, and InN. The function of each of the p-type semiconductor layers P1, P2, and P3 and the n-type semiconductor layers N1, N2, and N3 may be to provide holes and electrons to corresponding active layers A1, A2, and A3. Each of the p-type semiconductor layers P1, P2, and P3 may provide holes to the corresponding active layers A1, A2, and A3, and each of the n-type semiconductor layers N1, N2, and N3 may provide electrons to the corresponding active layers A1, A2, and A3. To this end, each of the p-type semiconductor layers P1, P2, and P3 may be doped with a p-type dopant, and each of the n-type semiconductor layers N1, N2, and N3 may be doped with an n-type dopant that is electrically different from the p-type dopant. Each of the p-type semiconductor layers P1, P2, and P3 may include magnesium (Mg), zinc (Zn), and the like as a dopant, and each of the n-type semiconductor layers N1, N2, and N3 may include silicon (Si), germanium (Ge), tin (Sn), and the like as a dopant.

Each of the active layers A1, A2, and A3 has a quantum well structure in which a quantum well is arranged between barriers. As electrons and holes provided in correspondence to and from the p-type semiconductor layers P1, P2, and P3 and the n-type semiconductor layers N1, N2, and N3 are recombined in the quantum well in each of the active layers A1, A2, and A3, light may be generated. The wavelength of light generated from each of the active layers A1, A2, and A3 may be determined according to the energy band gap of the material constituting the quantum well in each of the active layers A1, A2, and A3. Each of the active layers A1, A2, and A3 may have only one quantum well, but may have a multi-quantum well (MQW) structure in which a plurality of quantum wells and a plurality of barriers are alternately arranged. The thickness of each of the active layers A1, A2, and A3 or the number of quantum wells in each of the active layers A1, A2, and A3 may be appropriately selected in consideration of a voltage applied to the corresponding light-emitting elements 11, 12, and 13, light emission efficiency, and the like. Each of the active layers A1, A2, and A3 may include a group II-VI or III-V compound semiconductor material, particularly a nitride semiconductor material. For example, each of the active layers A1, A2, and A3 may include at least one nitride semiconductor material from among InGaN, GaN, AlGaN, and AlInGaN.

When each of the active layers A1, A2, and A3 includes indium (In), each of the active layers A1, A2, and A3 may emit light having a shorter wavelength as the indium content decreases. Light having a shorter wavelength may be emitted from the first light-emitting element 11 to the third light-emitting element 13. For example, the active layer A1 of the first light-emitting element 11 includes about 35 at% indium content to emit red light, the active layer A2 of the second light-emitting element 12 includes about 25 at% indium content to emit green light, and the active layer A3 of the third light-emitting element 13 includes about 15 at% indium content to emit blue light.

In addition, as the size of the light-emitting element decreases, the current density applied to the light-emitting element increases. As the current density increases, the external quantum efficiency in the light-emitting element decreases, and thus the light emission efficiency of the light-emitting element may also decrease. In the light-emitting device 100 according to an embodiment, since a plurality of light-emitting elements 11, 12, and 13 emitting light of different wavelengths are stacked in a vertical direction, that is, a light emission direction (e.g., a Z-axis direction), the active layers A1, A2, and A3 in a relatively wide area may be secured. The active layers A1, A2, and A3 in a wide area may reduce the current density applied to the light-emitting elements 11, 12, and 13, and the reduced current density may increase external quantum efficiency and increase light emission efficiency of the light-emitting elements.

The first light-emitting element 11, the second light-emitting element 12, and the third light-emitting element 13 have been described only with minimum components necessary for basic operation, but embodiments are not limited thereto. At least one of the first light-emitting element 11, the second light-emitting element 12, and the third light-emitting element 13 may further include various layers for improving performance. For example, carrier blocking layers and/or stress relief layers may be further arranged between the p-type semiconductor layers P1, P2, and P3 and the active layers A1, A2, and A3, and between the active layers A1, A2, and A3 and the n-type semiconductor layers N1, N2, and N3.

The light-emitting device 100 according to an embodiment may include a first insulating layer 21 arranged on a lower surface of the light-emitting structure 10. The first insulating layer 21 may include SiO₂, SiN, Al₂O₃, or the like. As the first insulating layer 21, the first light-emitting element 11, the second light-emitting element 12, and the third light-emitting element 13 are sequentially arranged in a Z-axis direction in the light-emitting structure 10, the bottom surface of the first insulating layer 21 may be the bottom surface of the light-emitting structure 10, and the top surface of the third light-emitting element 13 may be the top surface of the light-emitting structure 10.

The light-emitting device 100 according to an embodiment may further include one or more holes penetrating a partial area of the light-emitting structure 10. For example, the light-emitting structure 10 may include a first hole H1 that penetrates the third light-emitting element 13 and the second light-emitting element 12 from the top surface of the light-emitting structure 10 (the top surface of the third light-emitting element 13) to expose the n-type semiconductor layer N1 of the first light-emitting element 11, a second hole H2 that penetrates the third light-emitting element 13 from the top surface of the light-emitting structure 10 to expose the n-type semiconductor layer N2 of the second light-emitting element 12, a third hole H3 that penetrates the first insulating layer 21 to expose the p-type semiconductor layer P1 of the first light-emitting element 11, a fourth hole H4 that penetrates the first insulating layer 21 and the first light-emitting element 11 to expose the p-type semiconductor layer P2 of the second light-emitting element 12, and a fifth hole H5 that penetrates the first insulating layer 21, the first light-emitting element 11, and the second light-emitting element 12 from the bottom surface of the light-emitting structure 10 to expose the p-type semiconductor layer P3 of the third light-emitting element 13. The first hole H1, the second hole H2, the third hole H3, the fourth hole H4, and the fifth hole H5 may be spaced apart from each other in multiple directions.

Since the active region of the light-emitting structure 10 decreases by the widths of the first hole H1, the second hole H2, the third hole H3, the fourth hole H4, and the fifth hole H5, the widths of the first hole H1, the second hole H2, the third hole H3, the fourth hole H4, and the fifth hole H5 may be narrow. The width of each of the first hole H1, the second hole H2, the third hole H3, the fourth hole H4, and the fifth hole H5 may be equal to or less than 1/5 of the width of the light-emitting structure 10. For example, a width of each of the first hole H1, the second hole H2, the third hole H3, the fourth hole H4, and the fifth hole H5 may be about 1 µm or less or about 0.5 µm or less.

The light-emitting device 100 according to an embodiment may further include a second insulating layer 22 surrounding side surfaces of holes formed inside the light-emitting structure 10, that is, the first hole H1, the second hole H2, the fourth hole H4, and the fifth hole H5. The second insulating layer 22 may include SiO₂, SiN, Al₂O₃, or the like.

The light-emitting device 100 according to an embodiment may further include a first electrode pattern 30 electrically connected to each of the n-type semiconductor layers N1, N2, and N3 of the light-emitting structure 10 while being exposed on the top surface of the light-emitting structure 10 (i.e., the top surface of the third light-emitting element 13 or the top surface of the n-type semiconductor layer N3 of the third light-emitting element 13), and a second electrode pattern 40 electrically connected to each of the p-type semiconductor layers P1, P2, and P3 of the light-emitting structure 10 while being exposed on the bottom surface of the light-emitting structure 10 (i.e., the bottom surface of the first light-emitting element 11).

The first light-emitting element 11, the second light-emitting element 12, and the third light-emitting element 13 may receive a common voltage through one of the first electrode pattern 30 and the second electrode pattern 40, and may receive an independent driving voltage through the other of the first electrode pattern 30 and the second electrode pattern 40.

The first electrode pattern 30 may include a first electrode 31 electrically connected to the n-type semiconductor layer N1 of the first light-emitting element 11, a second electrode 32 electrically connected to the n-type semiconductor layer N2 of the second light-emitting element 12, and a third electrode 33 electrically connected to the n-type semiconductor layer N3 of the third light-emitting element 13. The first electrode 31 and the second electrode 32 may have conductive via shapes filling the first hole H1 and the second hole H2, respectively, and the third electrode 33 may have a conductive pad shape arranged in the n-type semiconductor layer N3 of the third light-emitting element 13.

The second electrode pattern 40 may include a fourth electrode 41 electrically connected to the p-type semiconductor layer P1 of the first light-emitting element 11, a fifth electrode 42 electrically connected to the p-type semiconductor layer P2 of the second light-emitting element 12, and a sixth electrode 43 electrically connected to the p-type semiconductor layer P3 of the third light-emitting element 13. The fourth electrode 41, the fifth electrode 42, and the sixth electrode 43 may include conductive via shapes filling the third hole H3, the fourth hole H4, and the fifth hole H5, respectively.

At least a portion of the first electrode pattern 30 and the second electrode pattern 40 may include a transparent conductive material. For example, at least some of the first electrode pattern 30 and the second electrode pattern 40 may include conductive oxides such as indium tin oxide (ITO), indium zinc oxide (IZO), indium tin zinc oxide (ITZO), conductive polymers such as poly(3,4-ethylenedioxythiophene) (PEDOT), and conductive materials such as Ag, Au, Pt, Ni, Cr, and/or Al. Alternatively, some of the second electrode pattern 40 may include a non-transparent conductive material or a conductive material having reflective properties.

The first light-emitting element 11 may emit red light based on an electric signal applied through the first electrode 31 and the fourth electrode 41, the second light-emitting element 12 may emit green light based on an electric signal applied through the second electrode 32 and the fifth electrode 42, and the third light-emitting element 13 may emit blue light based on an electric signal applied through the third electrode 33 and the sixth electrode 43.

When the first electrode pattern 30 applies a common voltage to the first to third light-emitting elements 11, 12, and 13, the first electrode 31, the second electrode 32, and the third electrode 33 may be arranged to be connected to each other. For example, the third electrode 33 may be arranged on the top surface of the light-emitting structure 10, that is, on the top surface of the n-type semiconductor layer N3 of the third light-emitting element 13, while contacting the first electrode 31 and the second electrode 32. However, embodiments are not limited thereto. Even when the first electrode 31 applies a common voltage to the first to third light-emitting elements 11, 12, and 13, at least one of the first electrode 31, the second electrode 32, and the third electrode 33 may be arranged not to be connected to the others. When the second electrode pattern 40 applies an independent driving voltage to each of the first to third light-emitting elements 11, 12, and 13, the fourth electrode 41, the fifth electrode 42, and the sixth electrode 43 may be arranged not to be connected to each other.

So far, it has been described that the first light-emitting element 11 emits red light, the second light-emitting element 12 emits green light, and the third light-emitting element 13 emits blue light. That is, the first light-emitting element 11 emits light having a longer wavelength than the second light-emitting element 12, and the third light-emitting element 13 emits light having a shorter wavelength than the second light-emitting element 12. However, embodiments are not limited thereto. The first light-emitting element 11 may emit light having a shorter wavelength than the second light-emitting element 12, or the third light-emitting element 13 may emit light having a longer wavelength than the second light-emitting element 12, and the wavelength of light emitted by the first light-emitting element 11, the second light-emitting element 12, and the third light-emitting element 13 may be determined according to the materials of the active layers A1, A2, and A3.

The substrate 330 may include an insulating material such as glass, an organic polymer, crystal, and the like. In addition, the substrate 330 may include a flexible material having flexibility to be bent or folded, and may have a single-layer structure or a multi-layer structure.

The drive layer 320 may include a buffer layer 321 arranged on the substrate 330 and a transistor TFT arranged on the buffer layer 321. The drive layer 320 may further include a driving voltage line, a scan driving unit, a data driving unit, a processor, and the like.

The buffer layer 321 may prevent diffusion of impurities into the transistor TFT. The buffer layer 321 may be provided as a single layer, but may be provided as at least a double layer or multiple layers.

When the buffer layer 321 is provided as multiple layers, each layer may include the same material or may include different materials. The buffer layer 321 may be omitted depending on the material and process conditions of the substrate 330.

The transistors TR1, TR2, and TR3 may drive a corresponding light-emitting element among a plurality of light-emitting elements included in the display layer 310. For example, the drive layer may include the first transistor TR1 driving the first light-emitting element 11, the second transistor TR2 driving the second light-emitting element 12, and the third transistor TR3 driving the third light-emitting element 13.

A protective layer 324 may be provided on the transistors TR1, TR2, and TR3. The protective layer 324 may include conductive vias CV1, CV2, and CV3. The fourth electrode 41 may be electrically connected to the first transistor TR1 (e.g., the drain of the first transistor TR1) through the first conductive via CV1, the fifth electrode 42 may be electrically connected to the second transistor TR2 (e.g., the drain of the second transistor TR2) through the second conductive via CV2, and the sixth electrode 43 may be electrically connected to the third transistor TR3 (e.g., the drain of the third transistor TR3) through a third conductive via CV3. The first electrode pattern 30 may also be connected to the circuit module of the drive layer 320 through a wiring.

When a common voltage is applied to each of the light-emitting elements 11, 12, and 13 through the first electrode pattern 30 and a driving voltage is applied to each of the light-emitting elements 11, 12, and 13 through the second electrode pattern 40, each of the light-emitting elements 11, 12, and 13 may independently emit light based on the applied voltage.

In order to output the light from the first light-emitting element 11 to the outside of the display apparatus 1, light output from the active layer A1 of the first light-emitting element 11 should pass through the n-type semiconductor layer N1 of the first light-emitting element 11, the second light-emitting element 12, and the third light-emitting element 13. In particular, as the thickness of the light-emitting structure 10 increases, the light emission efficiency of the light-emitting structure 10 decreases, and the deviation of the light emission efficiency between the active layers A1, A2, and A3 may also increase.

In order to increase the light emission efficiency, a method of reducing the thickness of the light-emitting structure 10 may be considered. The thickness of the light-emitting structure 10 depends upon the n-type semiconductor layers N1, N2, and N3 and the p-type semiconductor layers P1, P2, and P3. Therefore, it may be necessary to reduce the thicknesses of at least some of the n-type semiconductor layers N1, N2, and N3 and the p-type semiconductor layers P1, P2, and P3 in order to reduce the thickness of the light-emitting structure 10.

As described above, the p-type semiconductor layers P1, P2, and P3 and the n-type semiconductor layers N1, N2, and N3 may include a group II-VI or III-V compound semiconductor material, in particular a nitride semiconductor material. At least some of the p-type semiconductor layers P1, P2, and P3 and the n-type semiconductor layers N1, N2, and N3 may include a material having a high selectivity when forming the holes, thereby reducing a thickness.

In order to confirm the selective etching of a layer including GaN (hereinafter referred to as a "GaN layer") and a layer including AlGaN (hereinafter referred to as an "AlGaN layer"), the GaN layer, the AlGaN layer, and a p-type GaN layer were sequentially formed on the substrate, and then etching was performed from the surface of the p-type GaN layer toward the substrate. An etching gas was oxygen.

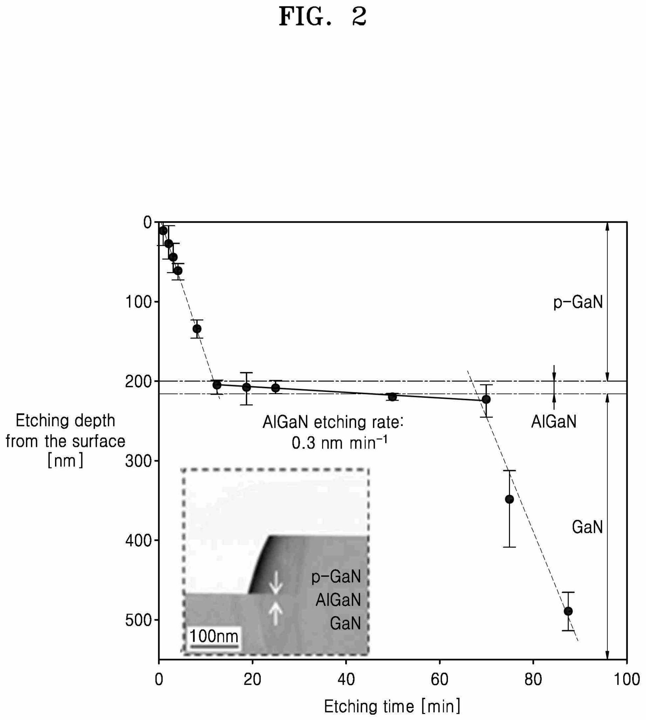

FIG. 2 is a graph illustrating selective etching of an AlGaN layer and a GaN layer according to an embodiment. Referring to FIG. 2, it may be seen that the AlGaN layer has an etching rate that is decreased compared to that of the GaN layer and the p-type GaN layer. It may be confirmed that aluminum has increased the etch resistance of GaN. Since the AlGaN layer has a slower etching rate than the GaN layer, the AlGaN layer may serve as an etching stop layer, and may have stable process dispersion. Therefore, at least some of the p-type semiconductor layers P1, P2, and P3 and the n-type semiconductor layers N1, N2, and N3 may include an AlGaN layer.

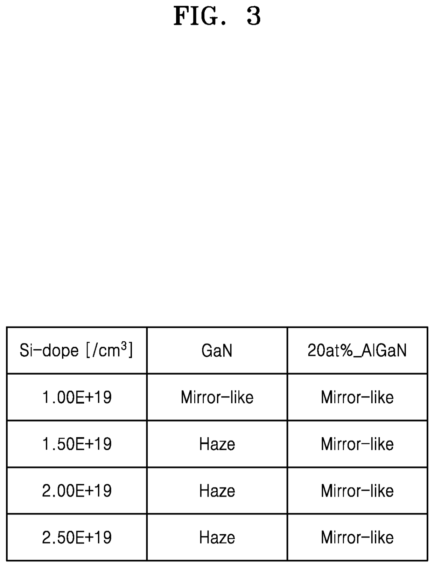

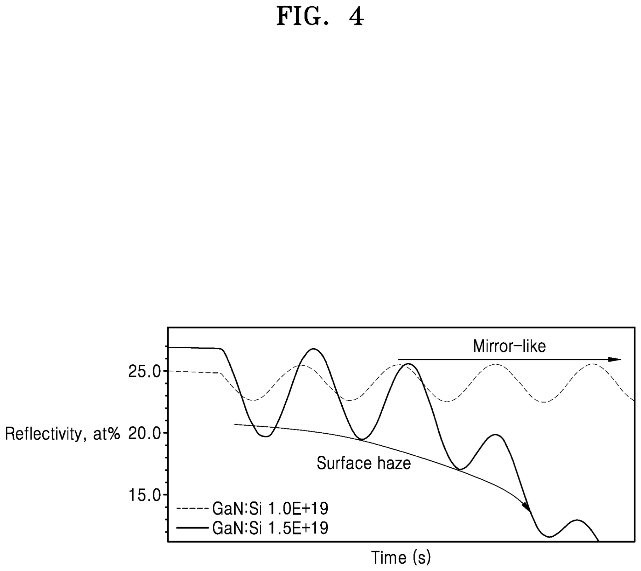

FIG. 3 is a table showing surface characteristics according to doping concentration of each material according to an embodiment, and FIG. 4 is a graph illustrating a result of analyzing reflectivity according to a doping concentration of a dopant according to an embodiment. The reflectivity may be a value represented by a log scale. Silicon, which is a kind of n-type dopant, was doped into a GaN-based layer and an AlGaN layer having an aluminum content of 20 at%. The surface characteristics of the layers according to the doping concentration of silicon are shown in FIG. 3. Referring to FIG. 3, when silicon is doped in the GaN layer at 1.00E+19/cm³, the surface of the GaN layer is a mirror-like surface, that is, a smooth surface such as a mirror. However, when silicon is doped at 1.5E+19/cm³ in the GaN layer, it may be seen that the surface of the GaN layer is not smooth and has fine roughness. On the other hand, it may be confirmed that the surface of the AlGaN layer with an aluminum content of 20 at% has a smooth surface, even though the doping concentration of silicon increases.

Referring to FIG. 4, it may be seen that the GaN layer doped with silicon at 1.00E+19/cm³ has a constant pattern of reflectivity according to a distance, whereas the GaN layer doped with silicon at 1.5E+19/cm³ has a pattern of decreased reflectivity as the distance increases. It may be found that as the silicon doping concentration increases, the surface quality of the GaN layer decreases.

Therefore, when the doping concentration of the n-type dopant is increased in the GaN layer, the properties deteriorate due to the surface GaN of the GaN layer, and thus there is a limit to reducing the thickness of the GaN layer. On the other hand, even if the doping concentration of the n-type dopant is increased in the AlGaN layer, the AlGaN layer may maintain excellent surface properties, and thus the thickness of the light-emitting structure 10 may be reduced by applying the AlGaN layer to the n-type semiconductor layer.

In an embodiment, the n-type semiconductor layer N1 of the first light-emitting element 11 may include an AlGaN layer doped with an n-type dopant. The n-type semiconductor layer N1 of the first light-emitting element 11 may be about 15 at% or more, about 20 at% or more, about 25 at% or more, or about 30 at% or more, and about 35 at% or less, about 40 at% or less, or about 45 at%. For example, the n-type semiconductor layer N1 of the first light-emitting element 11 may include an aluminum content of about 20 at% to about 40 at%.

A thickness of the n-type semiconductor layer N1 of the first light-emitting element 11 may be less than a thickness of the p-type semiconductor layer P1 of the first light-emitting element 11. A thickness of the n-type semiconductor layer N1 of the first light-emitting element 11 may be about 30 nm or more, about 50 nm or more, about 100 nm or more, or about 200 nm or more, or about 200 nm or less, about 300 nm or less, or about 400 nm or less. For example, a thickness of the n-type semiconductor layer N1 of the first light-emitting element 11 may be about 30 nm to about 300 nm. A thickness of the p-type semiconductor layer P1 of the first light-emitting element 11 may be about 50 nm or more or about 100 nm or more, and 300 nm or less, 400 nm or less, or 500 nm or less. For example, a thickness of the p-type semiconductor layer P1 of the first light-emitting element 11 may be about 50 nm to about 500 nm. In an embodiment, a distance d from the active layer A1 of the first light-emitting element 11 to the top surface of the light-emitting structure 10 may be 1000 nm or less, 1200 nm or less, or 1500 nm or less. In addition, the light emission efficiency of light emitted from the first light-emitting element to the outside of the light-emitting structure may be 35 % or more.

As the thicknesses of the n-type semiconductor layers N1, N2, and N3 decrease, it may be necessary to increase the doping concentration to provide sufficient electrons to the corresponding active layers A1, A2, and A3. A doping amount of the n-type dopant doped into the n-type semiconductor layer N1 of the first light-emitting element 11 according to an embodiment may be about 1.5E+19/cm³ or more, or about 2E+19/cm³ or more, and about 2.5E+19/cm³ or less, about 3.5E+19/cm³ or less, about 4E+19/cm³ or less, or about 5E+19/cm³ or less. For example, a doping amount of the n-type dopant doped into the n-type semiconductor layer N1 of the first light-emitting element 11 may be about 2E+19/cm³ to about 4E+19/cm³. Even if the doping concentration is high, the n-type semiconductor layer N1 of the first light-emitting element 11 including AlGaN may maintain stable surface quality.

The first electrode 31 electrically connected to the n-type semiconductor layer N1 of the first light-emitting element 11 may be impregnated in a partial region of the n-type semiconductor layer N1 of the first light-emitting element 11. For example, a thickness of the n-type semiconductor layer N1 of the first light-emitting element 11 contacting the first electrode 31 may be less than a thickness of the n-type semiconductor layer N1 of the first light-emitting element 11 not contacting the first electrode 31. Alternatively, a thickness of the n-type semiconductor layer N1 of the first light-emitting element 11 contacting the first electrode 31 may be equal to or less than half of a thickness of the n-type semiconductor layer N1 of the first light-emitting element 11 not contacting the first electrode 31. In other words, the first electrode 31 may penetrate the n-type semiconductor layer N1 to a depth that is less than or equal to half of the overall thickness of the n-type semiconductor layer N1 in the Z direction.

Like the n-type semiconductor layer N1 of the first light-emitting element 11, the n-type semiconductor layer N2 of the second light-emitting element 12 may include AlGaN doped with an n-type dopant and may include an aluminum content of 20 at% to 40 at%. A thickness of the n-type semiconductor layer N2 of the second light-emitting element 12 may be less than a thickness of the p-type semiconductor layer P2 of the second light-emitting element 12. For example, a thickness of the n-type semiconductor layer N2 of the second light-emitting element 12 may be about 30 nm to about 300 nm. In an embodiment, a doping amount of the n-type dopant doped into the n-type semiconductor layer N2 of the second light-emitting element 12 may be about 2E+19/cm³ to about 4E+19/cm³.

A thickness of the n-type semiconductor layer N3 of the third light-emitting element 13 may be greater than a thickness of the n-type semiconductor layer N1 of the first light-emitting element 11. The n-type semiconductor layer N3 of the third light-emitting element 13 may include GaN, and an aluminum content thereof may be 0 at%. A thickness of the n-type semiconductor layer N3 of the third light-emitting element 13 including GaN may be about 300 nm to about 5000 nm, or about 500 nm to about 2000 nm. The n-type semiconductor layer N3 of the third light-emitting element 13 includes GaN to maintain a predetermined thickness or more, thereby securing the straightness of light emitted from the third light-emitting element 13.

In an embodiment, at least one of the p-type semiconductor layers P1, P2, and P3 may have an aluminum content of 0 at%. For example, the p-type semiconductor layer P1 of the first light-emitting element 11, the p-type semiconductor layer P2 of the second light-emitting element 12, and the p-type semiconductor layer P3 of the third light-emitting element 13 may include GaN. Since it is difficult to dope the p-type semiconductor layers P1, P2, and P3 including AlGaN with a p-type dopant, the p-type semiconductor layers P1, P2, and P3 may include GaN having an aluminum content of 0 at%. At least one of the p-type semiconductor layer P1 of the first light-emitting element 11 and the p-type semiconductor layer P2 of the second light-emitting element 12 may be greater than the corresponding n-type semiconductor layer. On the other hand, the p-type semiconductor layer P3 of the third light-emitting element 13 may be smaller than the n-type semiconductor layer N3 of the third light-emitting element 13. For example, at least one of the p-type semiconductor layer P1 of the first light-emitting element 11, the p-type semiconductor layer P2 of the second light-emitting element 12, and the p-type semiconductor layer P3 of the third light-emitting element 13 may have a thickness of about 50 nm to about 500 nm.

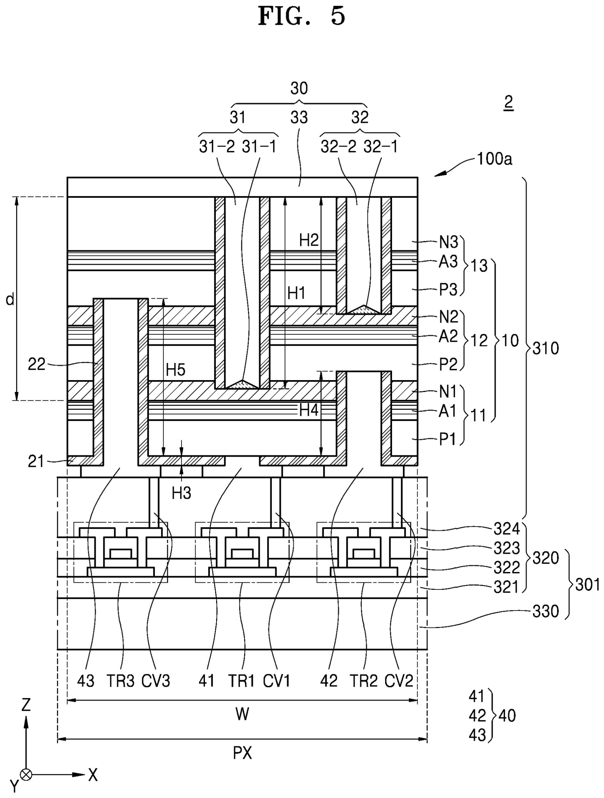

FIG. 5 is a diagram illustrating a portion of a display apparatus 2 according to an embodiment. When comparing FIG. 1 with FIG. 5, a first electrode 31 shown in FIG. 5 may include a first hole H1 including a second insulating layer 22, an n-type contact layer 31-1 contacting an n-type semiconductor layer N1 of a first light-emitting element 11 while being arranged in the first hole H1, and a conductive layer 31-2 contacting the n-type contact layer 31-1.

The n-type contact layer 31-1 may include the same material as the n-type semiconductor layer N1 of the first light-emitting element 11. For example, the n-type contact layer 31-1 may include a group II-VI or group III-V compound semiconductor material, such as a nitride semiconductor material. The n-type contact layer 31-1 may include an n-type dopant, for example, silicon (Si), germanium (Ge), tin (Sn), or the like.

The first hole H1 may be formed by an etching process. In the process of forming the first hole H1 by the etching process, the n-type semiconductor layer N1 of the exposed first light-emitting element 11 may be damaged, and thus diode junction characteristics or n-type semiconductor characteristics may be lost.

N-type semiconductor characteristics may be restored by forming an n-type contact layer 31-1 on the n-type semiconductor layer N1 of the exposed first light-emitting element 11. The content of the n-type dopant included in the n-type contact layer 31-1 may be greater than or equal to the content of the n-type dopant included in the n-type semiconductor layer N1 of the first light-emitting element 11. The n-type contact layer 31-1 may be grown on the n-type semiconductor layer N1 of the first light-emitting element 11. Carriers (e.g., holes) included in the n-type contact layer 31-1 may be diffused into the n-type semiconductor layer N1 of the first light-emitting element 11 to restore the n-type semiconductor characteristics of the n-type semiconductor layer N1.

In the n-type contact layer 31-1, a thickness of the n-type contact layer 31-1 in the edge region thereof differs from a thickness of the n-type contact layer 31-1 in the center region thereof when viewed across the X direction. The thickness of the n-type contact layer 31-1 may gradually increase from the edge region of the n-type contact layer 31-1 to the center region of the n-type contact layer 31-1. For example, a cross-sectional shape of the n-type contact layer 31-1 in the thickness direction of the light-emitting device 100 may be a triangular shape. Alternatively, the surface of the n-type contact layer 31-1 may be an r-surface. Since the surface of the n-type contact layer 31-1 has a convex shape, a contact area with the conductive layer 31-2 may be increased. Thus, contact resistance between the n-type contact layer 31-1 and the conductive layer 31-2 may be reduced.

The conductive layer 31-2 may protrude toward the surface of the first light-emitting element 11 while filling the first hole H1. For example, the conductive layer 31-2 and the n-type contact layer 31-1 may be arranged to at least partially overlap.

Since the first electrode 31 according to an embodiment includes the n-type contact layer 31-1, the n-type semiconductor layer N1 of the first light-emitting element 11 may restore the n-type semiconductor characteristics even if the n-type semiconductor characteristics are damaged.

Like the first electrode 31, the second electrode 32 of FIG. 5 may include an n-type contact layer 32-1 contacting the n-type semiconductor layer N2 of the second light-emitting element 12 and a conductive layer 32-2 contacting the n-type contact layer 32-1. The characteristics of the second electrode 32 are also the same as those of the first electrode 31, and thus a detailed description thereof is omitted.

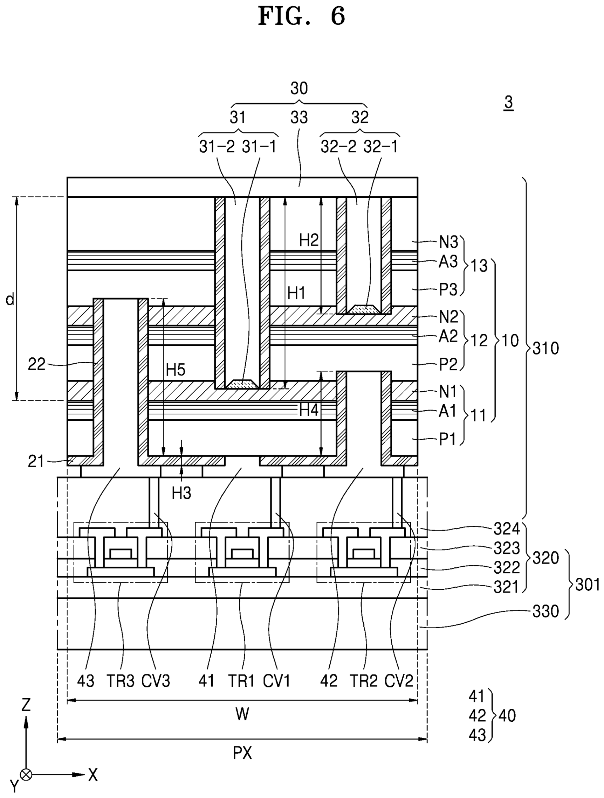

FIG. 6 is a diagram illustrating a portion of a display apparatus 3 according to an embodiment. When comparing FIG. 5 with FIG. 6, a shape of an n-type contact layer 31-1 illustrated in FIG. 6 is different from that of the n-type contact layer 31-1 illustrated in FIG. 5. A cross-sectional shape of the n-type contact layer 31-1 illustrated in FIG. 6 may have a trapezoidal cross-sectional shape in a thickness direction of the light-emitting structure 10. For example, the surface of the n-type contact layer 31-1 may include an r-surface and a c-surface. When the n-type contact layer 31-1 is grown on the n-type semiconductor layer N1 of the first light-emitting element 12, the cross-sectional shape of the n-type contact layer 31-1 may vary according to growth temperature and pressure. In addition, the cross-sectional shape of the n-type contact layer 31-1 in the thickness direction of the light-emitting device 100 may include a partial shape of a circle, a partial shape of an ellipse, or a partial shape of a polygon.

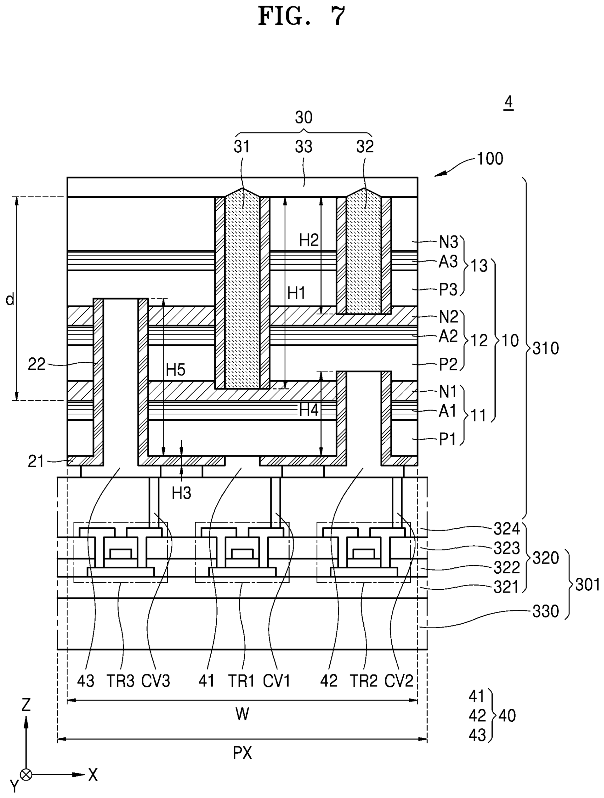

FIG. 7 is a diagram illustrating a portion of a display apparatus 4 according to an embodiment. When comparing FIG. 5 with FIG. 7, the n-type contact layer 31-1 in FIG. 7 may fill the first hole H1 to protrude toward the surface of the third light-emitting element 13. The ratio of the n-type contact layer 31-1 in the hole may vary depending on the degree of damage to the n-type semiconductor layer N1 of the first light-emitting element 11. The upper surface of the n-type contact layer 31 may be formed in a convex or concave shape (e.g., an arrow shape) that protrudes at least partially in the third electrode 33.

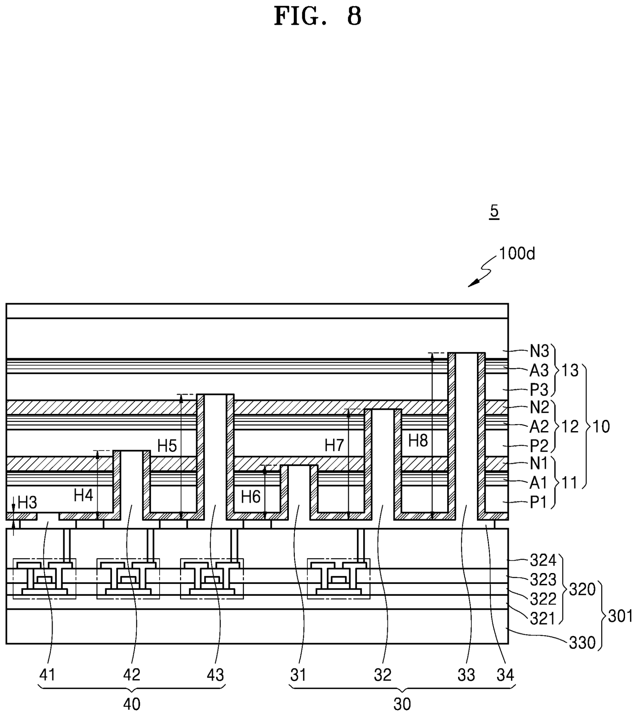

FIG. 8 is a diagram illustrating a display apparatus 5 including a light-emitting device in which electrode patterns are arranged on the same surface of a light-emitting structure according to an embodiment.

When comparing FIG. 1 with FIG. 8, a first electrode pattern 30 of FIG. 8 may be exposed on the bottom surface (i.e., the bottom surface of the first insulating layer 21) of the light-emitting structure 10 while being electrically connected to the n-type semiconductor layers N1, N2, and N3 of the light-emitting structure 10. For example, the first electrode pattern 30 may include a first electrode 31, which contacts the n-type semiconductor layer N1 of the first light-emitting element 11 through a first insulating layer 21, a p-type semiconductor layer P1 of the first light-emitting element 11, and an active layer A1 of the first light-emitting element 11, a second electrode 32, which contacts the n-type semiconductor layer N2 of the second light-emitting element 12 through the first insulating layer 21, the first light-emitting element 11, a p-type semiconductor layer P2 of the second light-emitting element 12, and a third electrode 33, which contacts the n-type semiconductor layer N3 of the third light-emitting element 13 through the first insulating layer 21, the second light-emitting element 12, the p-type semiconductor layer P3 of the third light-emitting element 13, and the active layer A3 of the third light-emitting element 13. In addition, the first electrode pattern 30 may further include a seventh electrode 34 arranged on the first insulating layer 21 while contacting the first electrode 31, the second electrode 32, and the third electrode 33.

The light-emitting device 100d shown in FIG. 8 includes holes H3, H4, H5, H6, H7, and H8 in the light-emitting structure 10 through a single etching process, thereby simplifying the process.

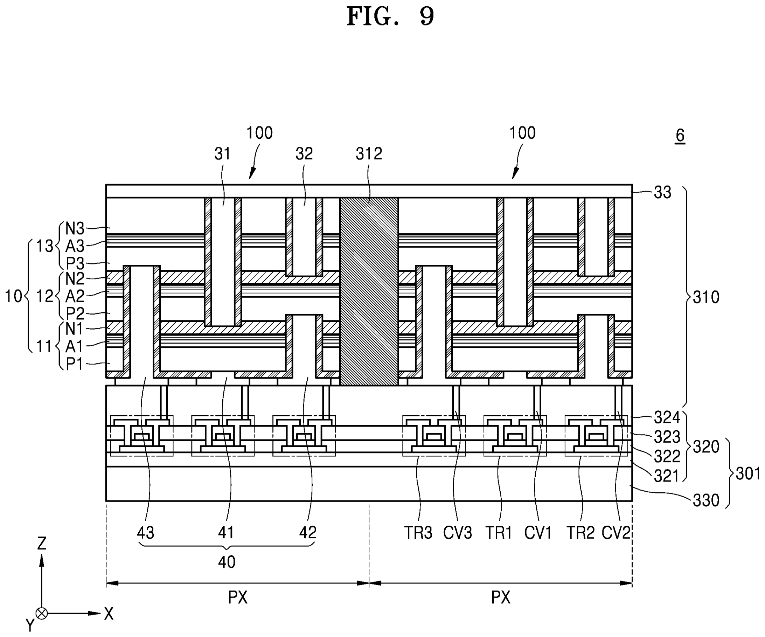

FIG. 9 is a diagram illustrating a display apparatus 6 including a pixel partition 312 according to an embodiment.

The display apparatus 6 of FIG. 9 may further include a pixel partition 312 arranged between the light-emitting devices 100. The pixel partition 312 may improve contrast by preventing mixing between beams of light emitted from the light-emitting devices 100. The pixel partition 312 may include at least one of a black matrix material, a resin, and a polymer.

The third electrodes 33 included in the neighboring light-emitting devices 100 may extend to the top surface of the pixel partition 312 to be connected to each other. For example, the third electrodes 33 included in the neighboring light-emitting devices 100 may be arranged on the same plane. Since the third electrodes 33 included in a plurality of light-emitting devices 100 are connected to each other, the number of circuit modules which applies a common voltage may be reduced.

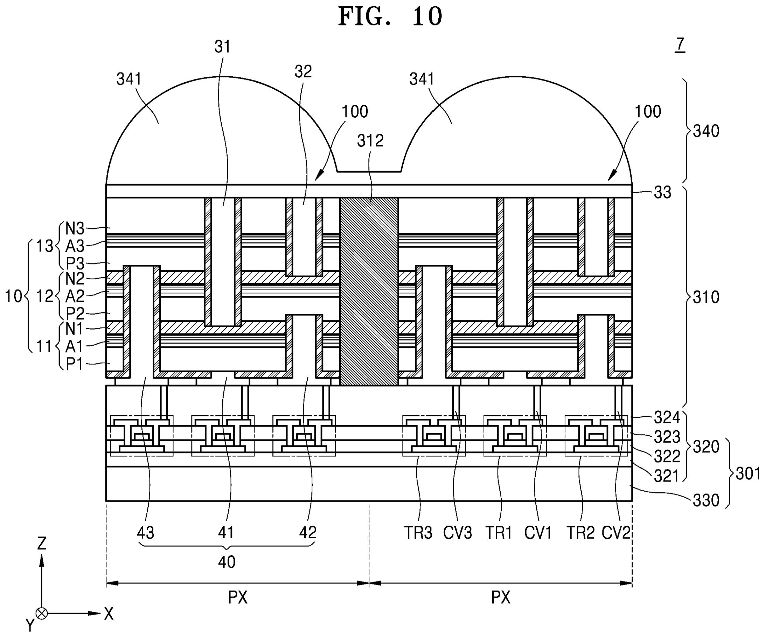

FIG. 10 is a diagram illustrating a display apparatus 7 including an optical layer 340 that controls an optical path according to an embodiment.

Referring to FIGS. 9 and 10, the display apparatus 7 of FIG. 10 may include an optical layer 340 arranged on the display layer 310 and controlling a path of light emitted from the display layer 310. The optical layer 340 may include a plurality of microlenses 341 arranged to correspond to the plurality of light-emitting devices 100 on a one-to-one basis. Each of the microlenses 341 may guide a traveling path of light in a specific direction by adjusting the traveling path of light emitted from the corresponding light-emitting device 100. Each of the microlenses 341 has a different refractive index and thus may focus light emitted from the display layer 310. Accordingly, the display apparatus 7 may generate an image having a small viewing angle. The optical layer 340 may enlarge or reduce the image generated by the display layer 310 according to the use of the display apparatus 7. In addition, the optical layer 340 may prevent the beams of light emitted from the adjacent light-emitting devices 100 from being mixed.

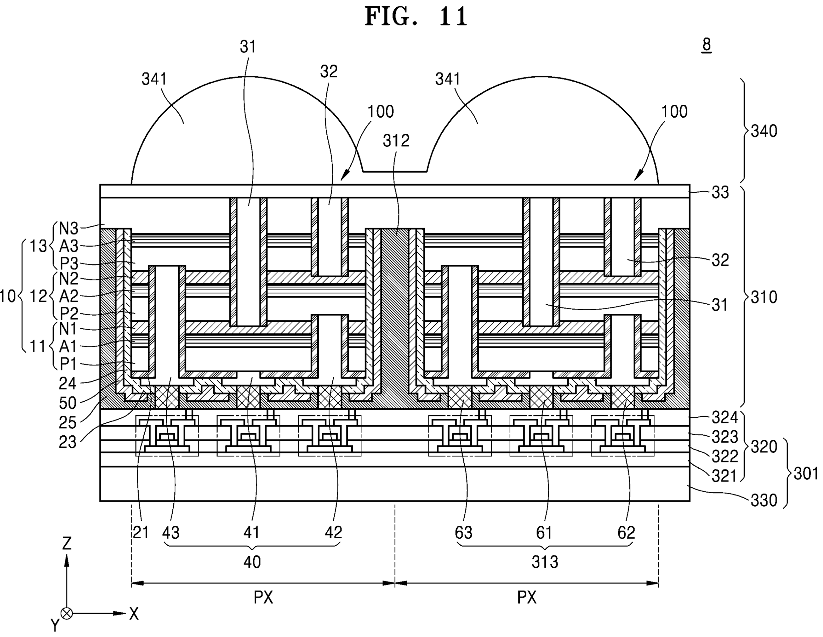

FIG. 11 is a diagram illustrating a display apparatus 8 to which light-emitting devices are connected according to an embodiment.

Referring to FIGS. 10 and 11, in the neighboring light-emitting devices 100 of the display apparatus 8 of FIG. 11, the n-type semiconductor layers N3 of each of the third light-emitting elements 13 may be connected to each other. Pixels PX may be partitioned by a pixel partition 312 penetrating a partial area of the light-emitting structure 10. The pixel partition 312 may be a trench penetrating the first light-emitting element 11, the second light-emitting element 12, the p-type semiconductor layer P3 of the third light-emitting element 13, and the active layer A3 of the third light-emitting element 13. The trench forms a closed loop, and the shape of the closed loop may be a cross-sectional shape of the pixel PX. For example, from the perspective of the thickness direction of the display layer 310, the cross-sectional shape of the pixel partition 312 may be a polygon, for example, a rectangle. When the cross-sectional shape of the pixel partition 312 is polygonal, the display apparatus 8 having a higher resolution when compared to the same area than the circular or elliptical cross-sectional shape may be implemented. A width of the pixel partition 312 may be determined by an interval between pixels PX. A fourth insulating layer 24 and a reflective layer 50 may be sequentially arranged on a side surface of the pixel partition 312.

The display layer 310 may further include a contact electrode pattern 313 for electrically connecting a fourth electrode 41, a fifth electrode 42, and a sixth electrode 43 to the drive layer 320. The contact electrode pattern 313 may include a first contact electrode 61 electrically connecting the fourth electrode 41 to the drive layer 320, a second contact electrode 62 electrically connecting the fifth electrode 42 to the drive layer 320, and a third contact electrode 63 electrically connecting the sixth electrode 43 to the drive layer 320. The contact electrode pattern 313 may include a conductive material. For example, the contact electrode pattern 313 may be a bonding metal such as Au, Sn, Cu, or the like.

The display layer 310 may further include a fifth insulating layer 25 filling the remaining space of the pixel partition 312 and the space between the display layer 310 and the drive layer 320. The fifth insulating layer 25 may include at least one of a black matrix material, a resin, and a polymer. However, embodiments are not limited thereto. The fifth insulating layer 25 may include a transparent inorganic material such as SiO₂.

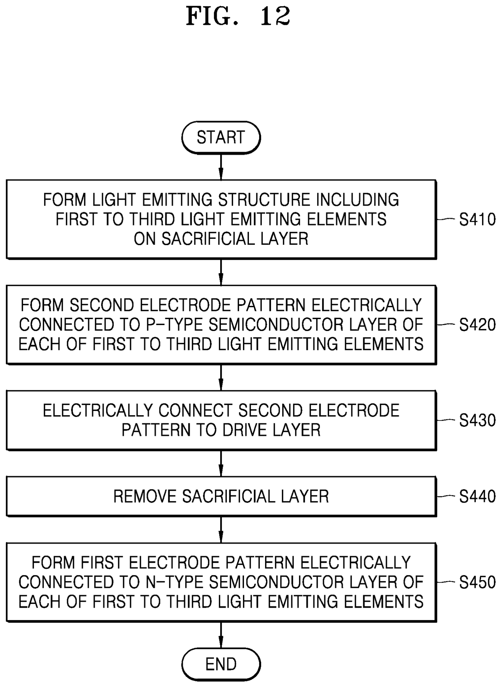

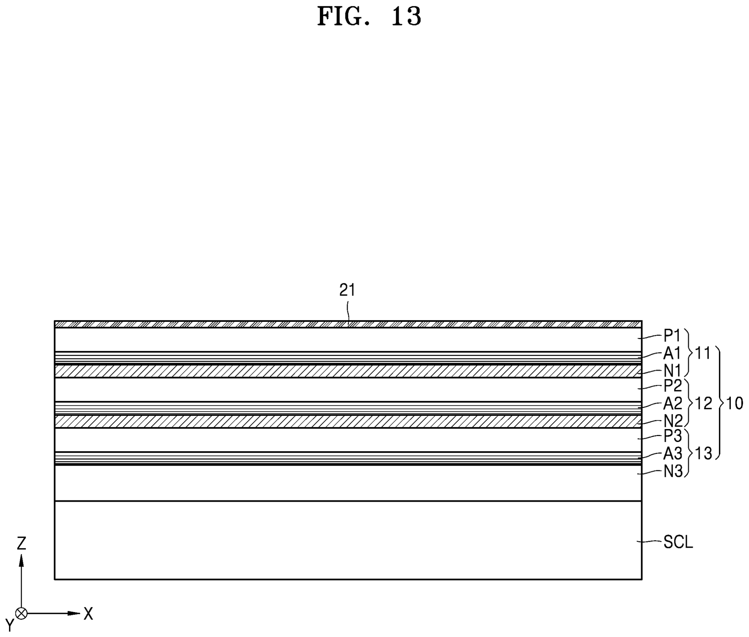

FIG. 12 is a flowchart illustrating a method of manufacturing a display apparatus 8, according to an embodiment, and FIGS. 13 to 22 are reference diagrams illustrating a method of manufacturing a display apparatus 8, according to an embodiment.

Referring to FIGS. 12 and 13, a light-emitting structure 10 may be formed on a sacrificial layer SCL in operation S410. The sacrificial layer SCL may be a layer for growing the light-emitting device 100. The sacrificial layer SCL may include various materials used in a general semiconductor process. For example, a silicon substrate, a sapphire substrate, or the like may be used as the sacrificial layer SCL.

The third light-emitting element 13, the second light-emitting element 12, and the first light-emitting element 11 may be sequentially and vertically formed on the sacrificial layer SCL. For example, the n-type semiconductor layer N3, the active layer A1, and the p-type semiconductor layer P1 of the third light-emitting element 13 may be sequentially grown on the sacrificial layer SCL, the n-type semiconductor layer N2, the active layer A1, and the p-type semiconductor layer P1 of the second light-emitting element 12 may be sequentially grown on the p-type semiconductor layer P3 of the third light-emitting element 13, and the n-type semiconductor layer N1, the active layer A1, and the p-type semiconductor layer P1 of the first light-emitting element 11 may be sequentially grown on the p-type semiconductor layer P2 of the second light-emitting element 12.

Among the first to third light-emitting elements 11, 12, and 13, the indium content included in the active layer A3 of the third light-emitting element 13 may be the lowest, and the indium content included in the active layer A1 of the first light-emitting element 11 may be the highest. In general, the lower the indium content, the higher the growth temperature of the nitride semiconductor, and thus the active layer may be grown with a relatively high growth temperature first and the active layer with a relatively low growth temperature later. When the active layer having a low indium content is first grown and the active layer having a high indium content is subsequently grown, the active layer having a high indium content may be degraded. The growth order of the light-emitting structure 10 according to an embodiment may prevent the active layer A1 of the first light-emitting element 11 having a high indium content from being deteriorated.

The light-emitting structure 10 according to an embodiment may not include a bonding material between the third light-emitting element 13, the second light-emitting element 12, and the first light-emitting element 11 light-emitting because the third light-emitting element 13, the second light-emitting element 12, and the first light-emitting element 11 are sequentially monolithically formed.

The light-emitting structure 10 may be formed using methods such as metal organic chemical vapor deposition (MOCVD), chemical vapor deposition (CVD), plasma-enhanced chemical vapor deposition (PECVD), molecular beam growth epitaxy (MBE), hydride vapor epitaxy (HVPE), etc.

A first insulating layer 21 may be further formed on the light-emitting structure 10, that is, the p-type semiconductor layer P1 of the first light-emitting element 11. The first insulating layer 21 may be formed by a CVD process.

In order to reduce the thickness of the light-emitting structure 10, at least one of the n-type semiconductor layer N1 of the first light-emitting element 11 and the n-type semiconductor layer N2 of the second light-emitting element 12 may include AlGaN. The aluminum content included in at least one of the n-type semiconductor layer N1 of the first light-emitting element 11 and the n-type semiconductor layer N2 of the second light-emitting element 12 may be about 15 at% or more, about 20 at% or more, about 25 at% or more, or about 30 at% or more, and about 35 at% or less, about 40 at% or less, or about 45 at% or less. For example, the n-type semiconductor layer N1 of the first light-emitting element 11 may include an aluminum content of about 20 at% to about 40 at%.

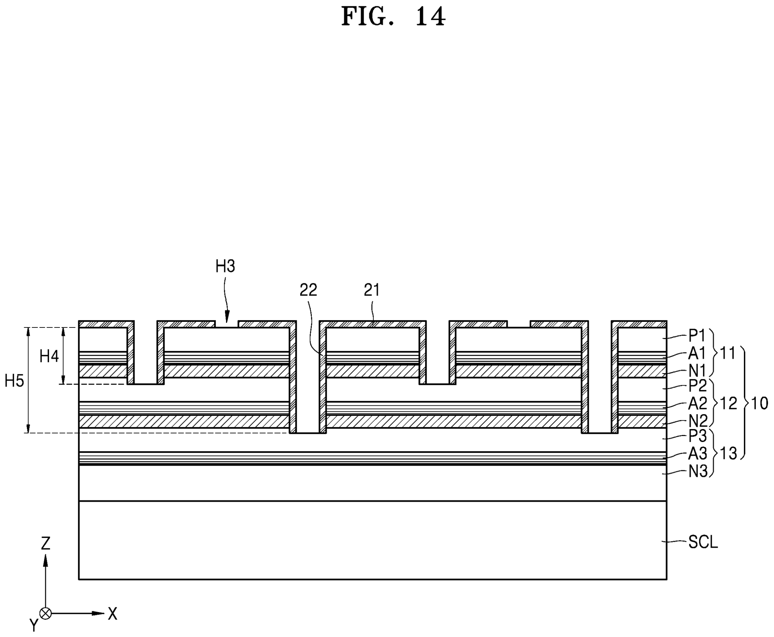

Referring to FIG. 14, a third hole H3 exposing the p-type semiconductor layer P1 of the first light-emitting element 11, a fourth hole H4 exposing the p-type semiconductor layer P2 of the second light-emitting element 12, and a fifth hole H5 exposing the p-type semiconductor layer P3 of the third light-emitting element 13 may be formed in the light-emitting structure 10, and a second insulating layer 22 surrounding side surfaces of the fourth hole H4 and the fifth hole H5 may be formed. Since the fourth hole H4 passes through the first light-emitting element 11, and the fifth hole H5 passes through the first light-emitting element 11 and the second light-emitting element 12, the active region of the light-emitting element may be reduced. Therefore, the narrower the widths of the fourth hole H4 and the fifth hole H5, the more preferable, and the widths of the fourth hole H4 and the fifth hole H5 may be about 1 µm or less or about 0.5 µm or less. The fourth hole H4 and the fifth hole H5 may be performed by a plasma etching process. Since the third hole H3 is formed by etching only the first insulating layer 21, an etching process other than a plasma etching process may be applied. For example, the third hole H3 may be formed by dry etching or wet etching.

The second insulating layer 22 may be formed by, for example, an atomic layer deposition process. Even though the first insulating layer 21 surrounds the side surfaces of the fourth hole H4 and the fifth hole H5, the p-type semiconductor layer P2 of the second light-emitting element 12 and the p-type semiconductor layer P3 of the third light-emitting element 13 may still be exposed to the outside.

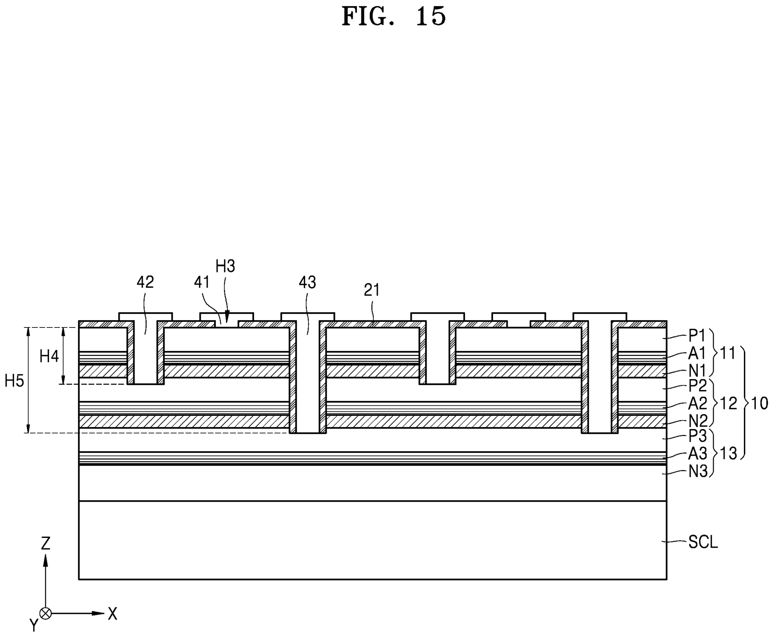

Referring to FIGS. 12 and 15, a second electrode pattern 40 may be formed on the light-emitting structure 10 in operation S420. That is, the fourth electrode 41 may be formed on the p-type semiconductor layer P1 of the first light-emitting element 11 exposed through the third hole H3, the fifth electrode 42 may be formed on the p-type semiconductor layer P2 of the second light-emitting element 12 exposed through the fourth hole H4, and the sixth electrode 43 may be formed on the p-type semiconductor layer P3 of the third light-emitting element 13 exposed through the fifth hole H5. The fourth electrode 41, the fifth electrode 42, and the sixth electrode 43 may be formed not to be connected to each other.

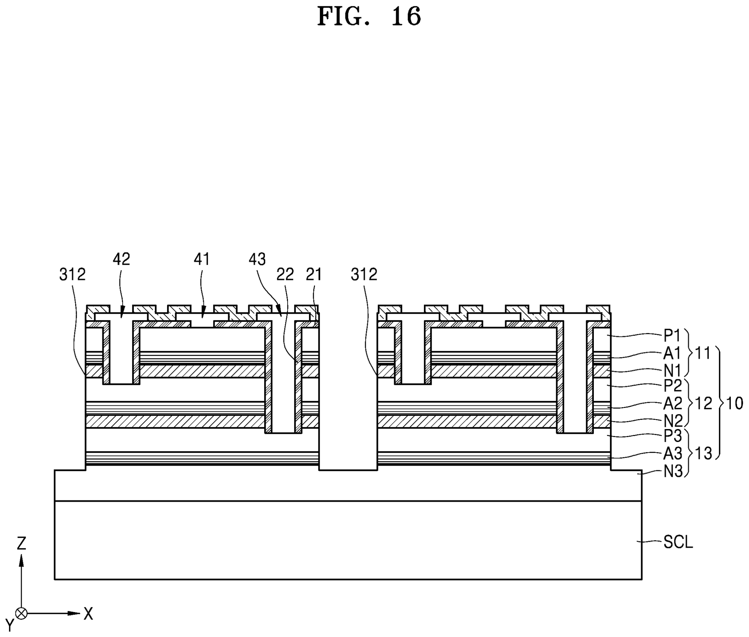

Referring to FIG. 16, a pixel partition 312 may be formed in the light-emitting structure 10. For example, the pixel partition 312 may be formed in a trench shape that penetrates the first light-emitting element 11, the second light-emitting element 12, the p-type semiconductor layer P3 of the third light-emitting element 13, and the active layer A3 of the third light-emitting element 13. A width of the pixel partition 312 may be an interval between pixels PX. In FIG. 16, it is shown that the pixel partition 312 does not penetrate the n-type semiconductor layer N3 of the third light-emitting element 13, but embodiments are not limited thereto. The pixel partition 312 may penetrate the n-type semiconductor layer N3 of the third light-emitting element 13. Since the pixel partition 312 does not penetrate the n-type semiconductor layer N3 of the third light-emitting element 13, durability of the display layer 310 may be increased.

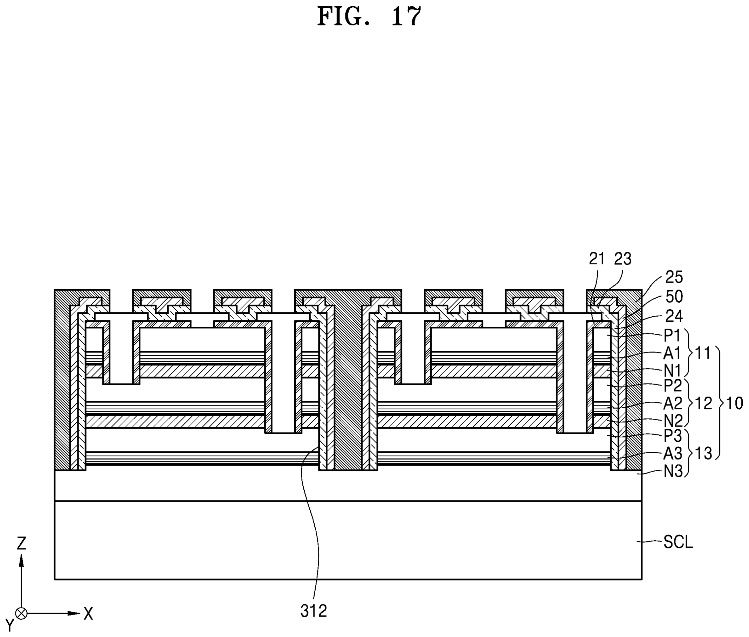

Referring to FIG. 17, a third insulating layer 23, a fourth insulating layer 24, a reflective layer 50, and a fifth insulating layer 25 may be formed on the light-emitting structure 10. A third insulating layer 23 may be formed on the first electrode pattern 30 and a fourth insulating layer 24 may be formed on the side of the pixel partition 312, and a reflective layer 50 may be formed on the third insulating layer 23 and the fourth insulating layer 24. The third insulating layer 23 and the reflective layer 50 may include holes exposing the fourth electrode 41, the fifth electrode 42, and the sixth electrode 43. The fifth insulating layer 25 may be formed to fill the remaining space of the pixel partition 312 while covering the entire reflective layer 50. The fifth insulating layer 25 may also include holes exposing the fourth electrode 41, the fifth electrode 42, and the sixth electrode 43. The third insulating layer 23 and the fourth insulating layer 24 may include a transparent insulating material, and the fifth insulating layer 25 may include an insulating material having elasticity. In addition, the reflective layer 50 may include a metal or the like.

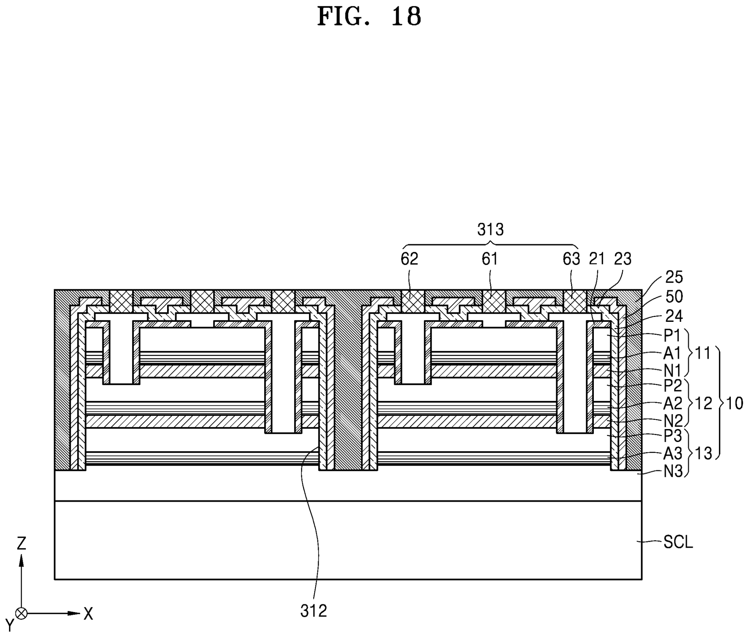

Referring to FIG. 18, a contact electrode pattern 313 including a first contact electrode 61, a second contact electrode 62, and a third contact electrode 63, which contact the fourth electrode 41, the fifth electrode 42, and the sixth electrode 43, may be formed while filling the holes of the fifth insulating layers 25. The first to third contact electrodes 61, 62, and 63 may include a conductive material having elasticity.

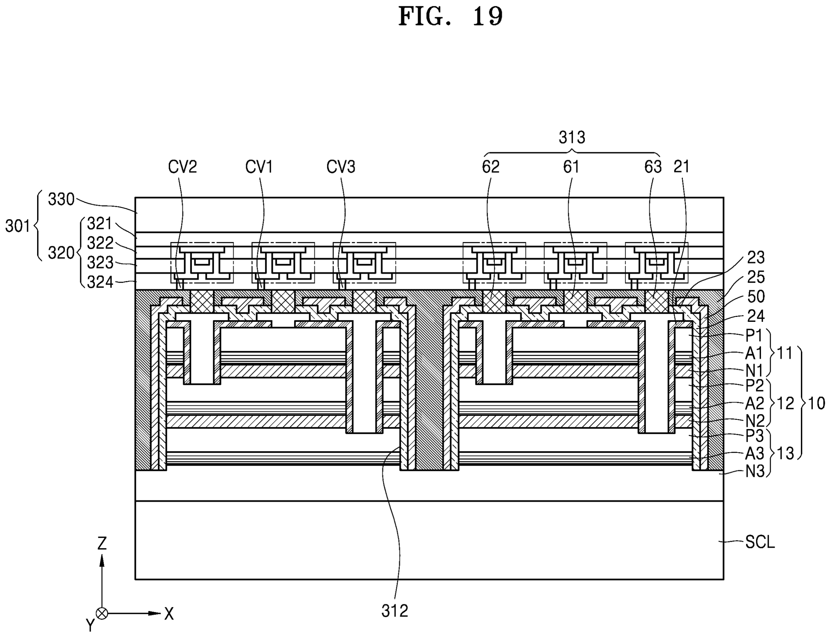

Referring to FIGS. 12 and 19, the second electrode pattern 40 may be electrically connected to the drive layer 320 in operation S430. For example, the contact electrode pattern 313 may be bonded to a backplane 301. The backplane 301 may include a first transistor TR1, a second transistor TR2, and a third transistor TR3 respectively driving the first light-emitting element 11, the second light-emitting element 12, and the third light-emitting element 13. A pad for the first electrode 31, a pad for the second electrode 32, and a third electrode pad, which are electrically connected to the first transistor TR1, the second transistor TR2, and the third transistor TR3, respectively, are arranged on the surface of the backplane 301. The backplane 301 may be bonded to the light-emitting device 100 so that the pad for the first electrode 31, the pad for the second electrode 32, and the third electrode pad are connected to the first contact electrode 61, the second contact electrode 62, and the third contact electrode 63 on a one-to-one basis. The backplane 301 may include various types of circuit modules in addition to transistors.

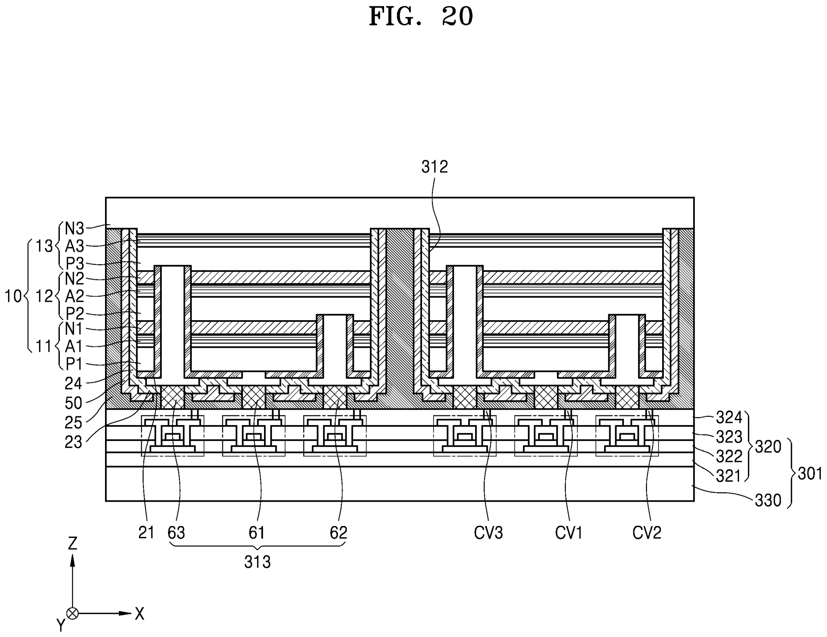

Referring to FIGS. 12 and 20, the sacrificial layer SCL may be removed from the light-emitting structure 10 in operation S440. After bonding the light-emitting structure 10 to the backplane 301, the vertical direction of the light-emitting structure 10 may be reversed so that the backplane 301 is arranged below the light-emitting structure 10. In addition, the sacrificial layer SCL may be removed from the light-emitting structure 10.

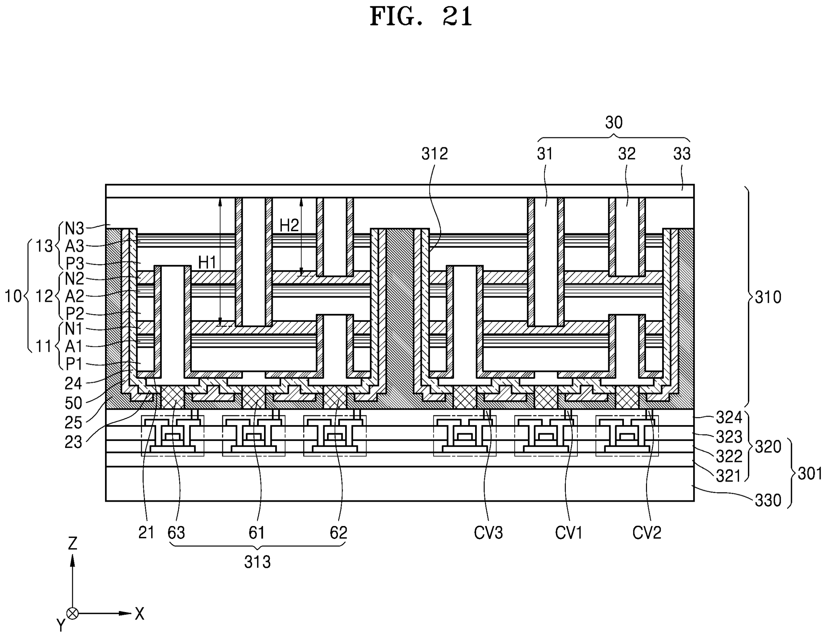

Referring to FIGS. 12 and 21, a first electrode pattern 30 may be formed on the light-emitting structure 10 in operation S450. First, the first hole H1 exposing the n-type semiconductor layer N1 of the first light-emitting element 11 and the second hole H2 exposing the n-type semiconductor layer N2 of the second light-emitting element 12 may be formed, and a second insulating layer 22 surrounding side surfaces of the first hole H1 and the second hole H2 may be formed. Since the first hole H1 passes through the third light-emitting element 13 and the second light-emitting element 12, and the second hole H2 passes through the third light-emitting element 13, the active areas A2 and A3 of the light-emitting elements 12 and 13 may be reduced. Therefore, the narrower the widths of the first hole H1 and the second hole H2, the more preferable, and the widths of the first hole H1 and the second hole H2 may be about 1 µm or less or about 0.5 µm or less.

The first hole H1 and the second hole H2 may be performed by an etching process. When the n-type semiconductor layer of the first light-emitting element and the n-type semiconductor layer of the second light-emitting element include AlGaN, AlGaN may function as an etching stop layer. Even if the thicknesses of the n-type semiconductor layer of the first light-emitting element and the n-type semiconductor layer of the second light-emitting element are small, the first hole H1 and the second hole H2 may be easily formed, and the process distribution may be improved.

The first electrode pattern 30 may be formed using the first hole H1 and the second hole H2. That is, the first electrode 31 may be formed on the n-type semiconductor layer N1 of the first light-emitting element 11 exposed through the first hole H1, the second electrode 32 may be formed on the n-type semiconductor layer N2 of the second light-emitting element 12 exposed through the second hole H2, and the third electrode 33 may be formed on the n-type semiconductor layer N3 of the third light-emitting element 13 exposed through the third hole H3. The third electrode 33 may be arranged on the n-type semiconductor layer N3 of the third light-emitting element 13 while being connected to the first electrode 31 and the second electrode 32. The third electrode 33 may cover the entire upper surface of the n-type semiconductor layer N3 of the third light-emitting element 13.

The first electrode pattern 30 is formed to be arranged on a surface (i.e., the surface of the third light-emitting element 13) that is different from the surface on which the backplane 301 is arranged after the light-emitting structure 10 is bonded to the backplane 301, thereby almost uniformly maintaining active areas in which the light-emitting elements 11, 12, and 13 are lost by the holes. In addition, the connection wiring between the circuit modules respectively corresponding to the first electrode pattern 30 and the second electrode pattern 40 may be simplified by arranging the first electrode pattern 30 and the second electrode pattern 40 on different surfaces of the light-emitting structure 10.

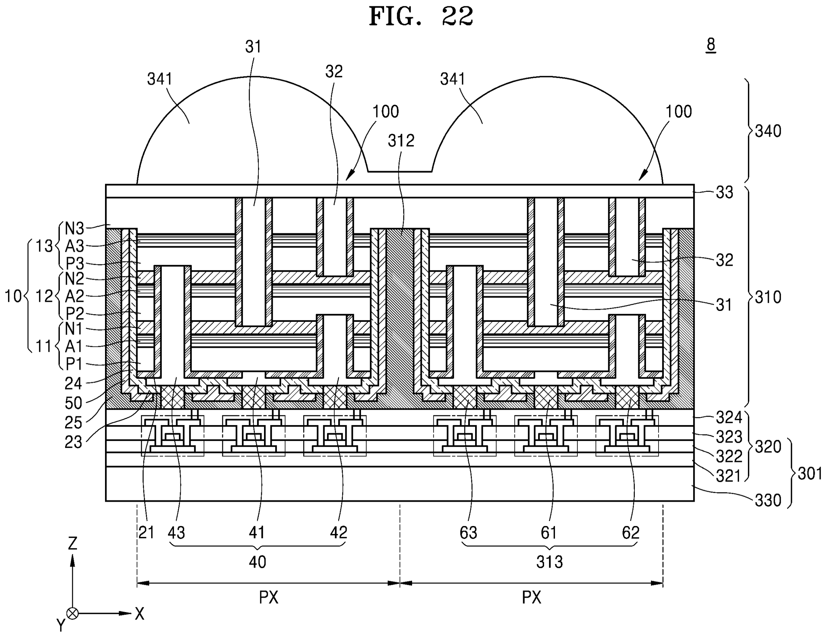

Referring to FIG. 22, an optical layer 340 may be formed on a top surface (e.g., a surface of the third light-emitting element 13) of the light-emitting structure 10. The optical layer 340 may control a traveling path of light generated by the light-emitting structure 10. Although the microlenses 341 are illustrated as optical elements in the drawing, embodiments are not limited thereto. The optical elements may be microstructures such as meta structures.

In the display apparatuses 1, 2, 3, 4, 5, 6, 7, and 8 described above, one pixel providing all blue light, green light, and red light may be implemented with only one light-emitting device 100. Therefore, the display apparatuses 1, 2, 3, 4, 5, 6, 7, and 8 may provide an ultra-high resolution image or may implement a compact display apparatus. The display apparatuses 1, 2, 3, 4, 5, 6, 7, and 8 may be applied to various electronic devices having a screen display function.

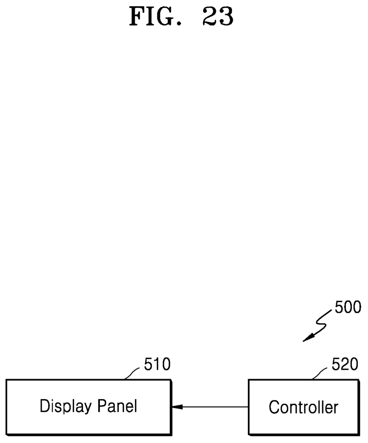

FIG. 23 is a block diagram schematically illustrating an electronic device 500 including a display apparatus according to an embodiment. Referring to FIG. 23, the electronic device 500 may include a display panel 510 and a controller 520. The display apparatuses 1, 2, 3, 4, 5, 6, 7, and 8 described above may be applied to the display panel 510. The controller 520 may control the display panel 510 based on image signals.

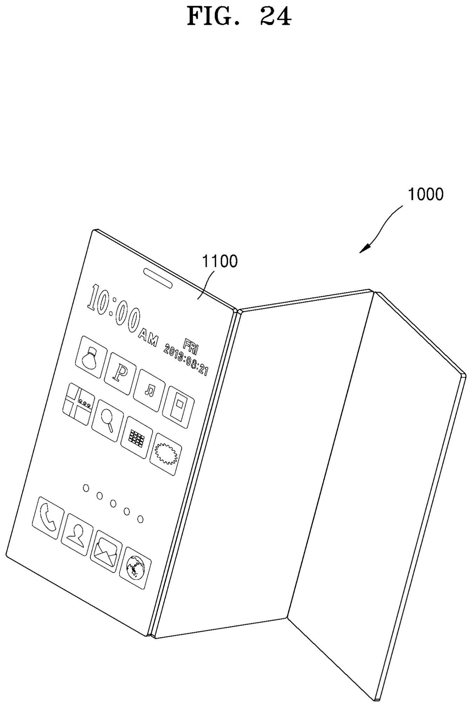

FIG. 24 illustrates an example in which a display apparatus according to an embodiment is applied to a mobile apparatus 1000. The mobile apparatus 1000 may include a display apparatus 1100. The display apparatus 1250 may include a display apparatus 1, 2, 3, 4, 5, 6, 7, or 8 according to an embodiment. The display apparatus 1100 may have a foldable structure, and may be implemented as, for example, a multi-folder display. Here, although it is illustrated that the mobile apparatus 1000 includes a folder-type display, the mobile apparatus 1000 may also include a flatpanel type display.

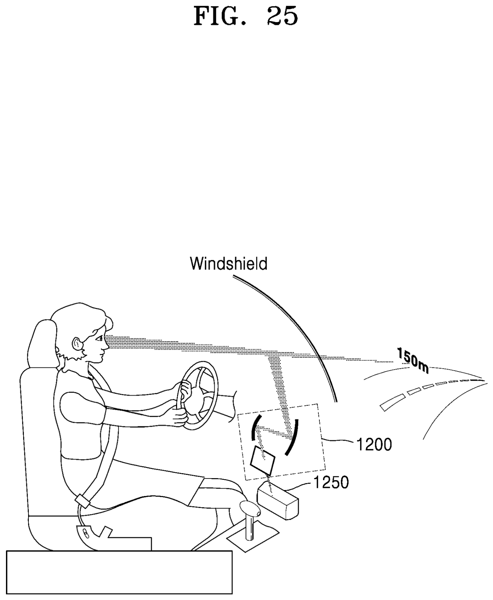

FIG. 25 is a diagram illustrating an example in which a display apparatus according to an embodiment is applied to a vehicle. The display apparatus may be implemented as a head-up display apparatus for a vehicle. The head-up display apparatus may include a display apparatus 1250 provided in one area of a vehicle and at least one optical path changing member 1200 that converts a path of light so that a driver may view an image generated by the display apparatus 1250. The display apparatus 1250 may include a display apparatus 1, 2, 3, 4, 5, 6, 7, or 8 according to an embodiment.

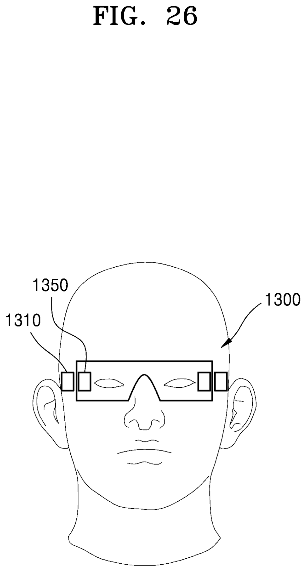

FIG. 26 is a diagram illustrating an example in which a display apparatus according to an embodiment is applied to augmented reality glasses or virtual reality glasses. The augmented reality glasses 1300 may include a projection system 1310 forming an image, and at least one element 1350 guiding an image from the projection system 1310 to enter the user's eye. The projection system 1310 may include a display apparatus 1, 2, 3, 4, 5, 6, 7, or 8 according to an embodiment.

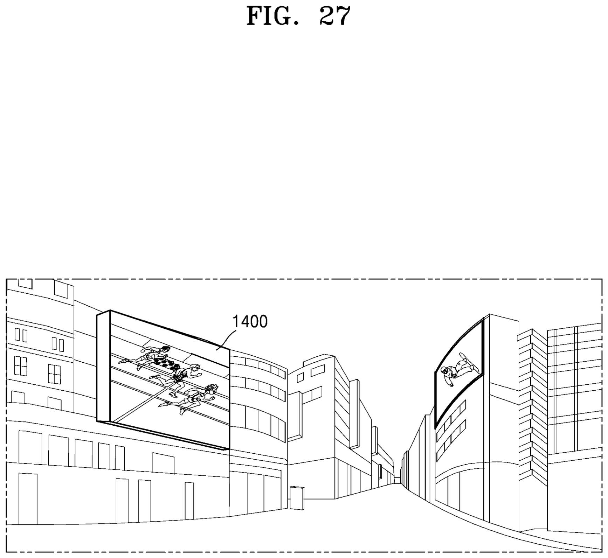

FIG. 27 is a diagram illustrating an example in which a display apparatus according to an embodiment is applied to a large signage. The signage 1400 may be used for outdoor advertising using a digital information display, and may control advertising content, etc. through a communication network. The signage 1400 may be implemented by adopting, for example, the display apparatus 1, 2, 3, 4, 5, 6, 7, or 8 according to an embodiment.

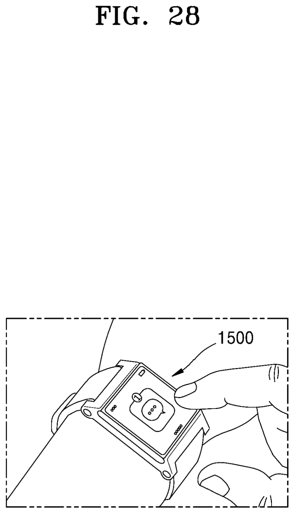

FIG. 28 is a diagram illustrating an example in which a display apparatus according to an embodiment is applied to a display of a wearable device. The display 1500 of the wearable apparatus may be implemented by adopting the display apparatus 1, 2, 3, 4, 5, 6, 7, or 8 according to an embodiment.

The display apparatus according to an embodiment may be applied to various products such as a rollable television (TV), a stretchable display, and the like.

A light-emitting structure according to an embodiment may emit light having a plurality of different wavelengths.

A light-emitting structure according to an embodiment may increase light emission efficiency by securing a wide active layer because a plurality of light-emitting elements are formed in a vertical stack shape.

When light-emitting devices according to an embodiment are used, a display apparatus may be manufactured without a high-level transfer technology.

A display apparatus according to an embodiment may increase light emission efficiency of a light-emitting structure and reduce a deviation in light emission efficiency for each light-emitting element.

Each of the embodiments provided in the above description is not excluded from being associated with one or more features of another example or another embodiment also provided herein or not provided herein but consistent with the disclosure.

While one or more embodiments have been described with reference to the figures, it will be understood by those of ordinary skill in the art that various changes in form and details may be made therein without departing from the scope as defined by the following claims.

## Claims

1. A display apparatus, comprising:
a display layer comprising a plurality of light-emitting devices; and
a drive layer configured to drive the plurality of light-emitting devices,
wherein at least one of the plurality of light-emitting devices comprises:
a light-emitting structure comprising a first light-emitting element, a second light-emitting element, and a third light-emitting element sequentially and monolithically stacked from the drive layer in a first direction, each of the first light-emitting element, the second light-emitting element, and the third light-emitting element comprising a p-type semiconductor layer, an active layer, and an n-type semiconductor layer, and being respectively configured to emit light of different wavelengths,
a first electrode pattern connected to the n-type semiconductor layer of the first light-emitting element, the n-type semiconductor layer of the second light-emitting element, and the n-type semiconductor layer of the third light-emitting element, and
a second electrode pattern electrically connected to the p-type semiconductor layer of the first light-emitting element, the p-type semiconductor layer of the second light-emitting element, and the p-type semiconductor layer of the third light-emitting element,
wherein the n-type semiconductor layer of the first light-emitting element comprises AlGaN, and
wherein a doping amount of an n-type dopant in the n-type semiconductor layer of the first light-emitting element is 2E+19/cm³ or more.

2. The display apparatus of claim 1, wherein an aluminum content in the n-type semiconductor layer of the first light-emitting element is in a range of 20 at% to 40 at%.

3. The display apparatus of claim 1 or 2, wherein the p-type semiconductor layer of the first light-emitting element comprises GaN, and comprises an aluminum content of 0 at%.

4. The display apparatus of any of the previous claims, wherein, in the first direction, a thickness of the n-type semiconductor layer of the first light-emitting element is less than a thickness of the p-type semiconductor layer of the first light-emitting element; and/or
wherein, in the first direction, a thickness of the n-type semiconductor layer of the first light-emitting element is less than a thickness of the n-type semiconductor layer of the third light-emitting element.

5. The display apparatus of any of the previous claims, wherein, in the first direction, the n-type semiconductor layer of the first light-emitting element has a thickness in a range of 30 nm to 300 nm.

6. The display apparatus of any of the previous claims, wherein the n-type semiconductor layer of the third light-emitting element comprises GaN, and comprises an aluminum content of 0 at%.

7. The display apparatus of any of the previous claims, wherein, in the first direction, a distance from the active layer of the first light-emitting element to a surface of the light-emitting structure is 1500 nm or less.

8. The display apparatus of any of the previous claims, wherein the first electrode pattern comprises a first electrode that penetrates the second light-emitting element and the third light-emitting element in the first direction and contacts the n-type semiconductor layer of the first light-emitting element,
wherein, preferably:
in the first direction, the first electrode penetrates less than halfway through the n-type semiconductor layer of the first light-emitting element; and/or
in the first direction, the first electrode penetrates less than or equal to half of a thickness of the n-type semiconductor layer of the first light-emitting element.

9. The display apparatus of claim 8, wherein the first electrode comprises:
a first hole comprising an insulating material, penetrating the second light-emitting element and the third light-emitting element in the first direction, and exposing the n-type semiconductor layer of the first light-emitting element;
a first n-type contact layer in the first hole and contacting the n-type semiconductor layer of the first light-emitting element; and
a first conductive layer in the first hole and contacting the first n-type contact layer.

10. The display apparatus of claim 9, wherein, in the first direction, a thickness of the first n-type contact layer in an edge region of the first n-type contact layer is different from a thickness, in the first direction of the first n-type contact layer in a center region of the first n-type contact layer, and
wherein the center region and the edge region are spaced apart in a second direction perpendicular to the first direction,
wherein, preferably:
in the first direction, a thickness of the first n-type contact layer gradually increases from an edge region of the first n-type contact layer to a center region of the first n-type contact layer, and
the center region and the edge region are spaced apart in a second direction perpendicular to the first direction.

11. The display apparatus of claim 9 or 10, wherein the first conductive layer protrudes toward the third light-emitting element.

12. The display apparatus of any of the claims 9-11, wherein the first n-type contact layer protrudes toward the third light-emitting element.

13. An electronic device, comprising:
a display panel comprising a display layer comprising a plurality of light-emitting devices and a drive layer configured to drive the plurality of light-emitting devices, and
a controller configured to control the display panel based on an image signal,
wherein at least one of the plurality of light-emitting devices comprises:
a light-emitting structure comprising a first light-emitting element, a second light-emitting element, and a third light-emitting element sequentially and monolithically stacked in a first direction, each of the first light-emitting element, the second light-emitting element, and the third light-emitting element comprising a p-type semiconductor layer, an active layer, and an n-type semiconductor layer, and being respectively configured to emit light of different wavelengths,
a first electrode pattern connected to the n-type semiconductor layer of the first light-emitting element, the n-type semiconductor layer of the second light-emitting element, and the n-type semiconductor layer of the third light-emitting element, and
a second electrode pattern electrically connected to the p-type semiconductor layer of the first light-emitting element, the p-type semiconductor layer of the second light-emitting element, and the p-type semiconductor layer of the third light-emitting element,
wherein the n-type semiconductor layer of the first light-emitting element comprises AlGaN, and
wherein a doping amount of an n-type dopant in the n-type semiconductor layer of the first light-emitting element is 2E+19/cm³ or more.

14. A method of manufacturing a display apparatus, the method comprising:
forming a light-emitting structure comprising a first light-emitting element, a second light-emitting element, and a third light-emitting element stacked in a first direction, wherein each of the first light-emitting element, the second light-emitting element, and the third light-emitting element comprises a p-type semiconductor layer, an active layer, and an n-type semiconductor layer, and are respectively configured to emit light of different wavelengths;
forming a second electrode pattern connected to the p-type semiconductor layer of the first light-emitting element, the p-type semiconductor layer of the second light-emitting element, and the p-type semiconductor layer of the third light-emitting element;
connecting the second electrode pattern to a drive layer that is configured to drive the light-emitting structure;
removing a sacrificial layer from the light-emitting structure; and
forming a first electrode pattern connected to the n-type semiconductor layer of the first light-emitting element and the n-type semiconductor layer of the second light-emitting element,
wherein the n-type semiconductor layer of the first light-emitting element comprises AlGaN, and
wherein a doping amount of an n-type dopant in the n-type semiconductor layer of the first light-emitting element is 2E+19/cm³ or more.

15. The method of claim 14, wherein, in the first direction, a thickness of the n-type semiconductor layer of the first light-emitting element is less than a thickness of the p-type semiconductor layer of the first light-emitting element; and/or
wherein, in the first direction, a thickness of the n-type semiconductor layer of the first light-emitting element is in a range of 100 nm to 300 nm.
